# EUROPEAN PATENT APPLICATION

(11) **EP 0 817 187 A2**
(43) Date of publication of application: **07.01.1998**
(21) Application number: 97202993.8
(22) Date of filing: 05.05.1995
(51) Int. Cl.: G11B 20/10, G11B 7/00, G11B 11/10

(54) **Apparatus and method for retrieving stored data**

(30) Priority: 06.05.1994 US 238831; 13.01.1995 US 372205
(62) Divisional of application: 95303079.8
(71) Applicant: DISCOVISION ASSOCIATES, Irvine, CA 92714 (US)
(72) Inventor: Kimura, Noboru, Torrance, CA 90505 (US); Yeh, Wen-Yung, Agoura Hills, CA 91301 (US)
(74) Representative: Vuillermoz, Bruno

(57) **Abstract**

An apparatus for retrieving stored data from an information storage medium, said apparatus comprising:
an input stage for generating a signal having a predetermined waveform including positive and negative peaks corresponding to said stored data;
an integrator stage for integrating at least a portion of said signal to output a preprocessed signal having a predetermined waveform including said positive peaks, negative peaks, and a DC component;
a data generator for generating a threshold signal which varies with said DC component of said preprocessed signal, and for generating an output data waveform signal indicative of said stored data by comparing said preprocessed signal and said threshold signal, said data generator including;
a positive peak detector for receiving said preprocessed signal to measure and track said positive peaks and to output a positive peak signal;
a negative peak detector for receiving said preprocessed signal to measure and track said negative peaks and to output a negative peak signal;
a voltage divider for averaging said negative peak signal and said positive peak signal to thereby generate a voltage divider output; and
a comparator for receiving said voltage divider output and comparing said preprocessed signal with a divided voltage corresponding to said threshold signal to thereby generate said output data waveform signal.

## Description

This invention relates to methods of storing and retrieving data from a storage device and apparatus therefor. Recordable/erasable optical disks are currently available for use as data storage media. Magneto-optical recording is a technique commonly used to store and/or retrieve the data from the disk. During recording, a magnetic field orients the polarity of a generalized area on the disk, while a laser pulse heats a localised area thereby fixing the polarity of the smaller area. The localised area with fixed polarity is commonly called a pit. Some encoding systems use the existence or absence of a pit on the disk to define the recorded data as a '1' or '0', respectively The most commonly used encoding system for this pit-type recording is the run length limited (RLL) 2,7 code because it gives the highest data-to-pit ratio. This type of recording however does not lead to higher density because amplitude and timing margins deteriorate very rapidly as frequency is increased.
Although there has been a continual demand for disk systems capable of storing increasingly higher data densities, the ability to achieve higher data storage densities has met with several limitations. As a general matter, the reasonable upper limit for data density is determined in part by reliability requirements, the optical wavelength of laser diodes, the quality of the optical module, hardware cost, and operating speed, maximum data density are also affected by the ability to reject various forms of noise, including interference and distortion. For example, the denser data is packed, the more intersymbol interference will prevent accurate data recovery. Moreover, because the technology for may intermediate and high performance optical disk drives has been limited by downward compatibility constraints to older models, signal processing techniques have not advanced as rapidly as they might otherwise have done.
When attempting to recover stored data, existing read channels of magneto-optical and other types of disk drives commonly suffer from a number of problems due to the unintentional build-up of dc components in the read signal. One cause of do build-up results in the recording of asymmetrical data patterns over a number of bytes or data segments. A symmetrical data pattern may be considered as one having an average dc component of zero over a region of interest. Because sequences of recorded bits may be essentially random in many modulation codes, however, localized regions of recorded data having particular patterns of l's and O's will produce an asymmetrical read signal having an unwanted dc component. Because the data patterns vary over time, the level of dc build up will also vary, causing wander or drift of the dc level, reduction of threshold detection margins and greater susceptibility to noise and other interference.
Undesired dc build-up is also caused by variations in pit size due to thermal effects on the writing laser or the storage medium. As the writing laser heats up, for example, the spot size may increase, leading to wider pits. When the recorded pits are read, variations in pit size will cause an asymmetrical input signal having dc components. Variation in pit size not only causes undesired dc build-up but also causes the relative locations of the data shifted in time, reducing the timing margin and leading to possible reading errors.
Various attempts have been made to overcome the described problems. For example, vanous tape drive systems commonly use dc-free codes such as a 0/3/8/10 code, otherwise referred to simply as an 8/10 code. Because an 8/10 code requires 10 stored bits to yield 8 data bits, however, it is only 80% efficient which is a drawback when attempting to record data in high density.
It would therefore, be advantageous to have a method and device for reading stored data from a medium without suffering the undesirable effects of dc build-up, without creating unacceptable levels of noise or significant reducing timing margins and without the requirement of large amounts of overhead or derandomizing algorithms, while providing high data storage efficiency.
According to the invention, the above noted problems are solved by a method for retrieving data stored on a medium such as a magneto-optical disk, comprising the steps of reading the stored data and generating a playback signal therefrom, partially integrating the playback signal, generating a threshold signal which varies with a dc component of the partially integrated signal, and generating an output signal indicative of the stored data by comparing the partially integrated signal with the threshold signal.
According to an aspect of the invention, the playback signal is differentiated prior to the step of partially integrating.

According to another aspect of the invention, the step of partially integrating comprising integrating the playback signal and simultaneously but separately, band pass filtering the playback signal, and taking a difference between the integrated signal and the band pass filter signal. The different signal is then subjected to low-pass filtering. According to another aspect of the invention, the step of generating a threshold signal comprises detecting a positive peak voltage of the partially integrated signal, detecting a negative pea voltage of the partially integrated signal, and averaging the positive peak voltage and the negative peak voltage. The threshold signal is adjusted in response to a state of the output signal by decreasing a detected positive peak voltage when the output signal is in one of either a low state or high state, and decreasing a detected negative peak voltage when the output signal is in the other of the low state or high state.
In a preferred embodiment the threshold signal corresponds to an approximate midpoint of the partially integrated signal, and the adjustment of the threshold signal is proportional to a duty cycle of the output signal.
According to another aspect of the invention the step of partially integrating the signal comprises integrating the playback signal, simultaneously but separately with the integrating, band pass filtering the playback signal, and taking a difference between the integrated signal id the band pass filter signal.
In one preferred embodiment a method for retrieving data information from a playback signal comprises the steps of differentiating the playback signal, equalising the differentiated signal, partially integrating the equalised signal, generating a threshold signal which tracks the dc component of the partially integrated signal, generating an output signal by comparing the partial integrated signal with the threshold signal and adjusting the threshold signal in response to the output signal.
The invention provides an apparatus for retrieving data stored on a medium, such as an optical disk comprising a reader for the stored data that generates an output signal, a partial integrator connected to the signal, a threshold generator connected to the partial integrator, a data generator connected to the partial integrated and the threshold generator, the data generator comprising a comparator, and a feedback path from the comparator to the threshold generator. The comparator is connected to an output from the threshold generator and an output of the partial integrator. The threshold generator generates a threshold signal which varies with a dc component of the signal and corresponds to its approximate midpoint.
In a preferred embodiment the reader includes a differentiator.
According to an aspect of the invention the partial integrator is a section that includes an integrator connected to the signal, a band pass filter connected to the signal, and a substractor connected to an output of the integrator and an output of the band pass filter.
A low-pass filter is connected to an output of the substractor.
In a preferred embodiment the threshold generator comprises a positive peak voltage detector connected to the partial integrator, a negative peak voltage detector connected to the partial integrator, and a voltage divider connected to an output of the positive peak voltage detector and an output of the negative peak voltage detector.
The feedback path is connected to the positive peak voltage detector and to the negative peak voltage detector and causes an adjustment to a detected positive peak voltage or to a detected negative peak voltage independent on a state of the feedback path. The detected positive peak voltage is adjusted by decreasing its magnitude when the feedback path is in one of two states, and the detected negative peak voltage is adjusted by decreasing its magnitude when the feedback path is another of the two states.
In one embodiment an apparatus is provided for locating transitions in the signal having a dc component, the apparatus comprising means for reading data stored on a medium and generating a signal thereby, means for waveform, restoration connected to the signal, a threshold generator connected to the waveform restoration means, a data generator connected to the signal and to the threshold generator, the data generator comprising a comparator and a feedback path from the comparator to the threshold generator.
Also according to the invention, a method for storing and retrieving digital data on an optical disk is provided. For writing on the disk, a binary signal having first and second binary values at a given clock interval is generated. Energising pulses that have a duration less than the clock interval are generated during each clock interval having one of the binary values. The energising pulses turn a laser beam on and off depending on the binary signal. The laser beam is focused on a recording surface of a rotating disk such that the laser beam can selectively access one of a plurality of concentric spiral tracks on the recording surface.

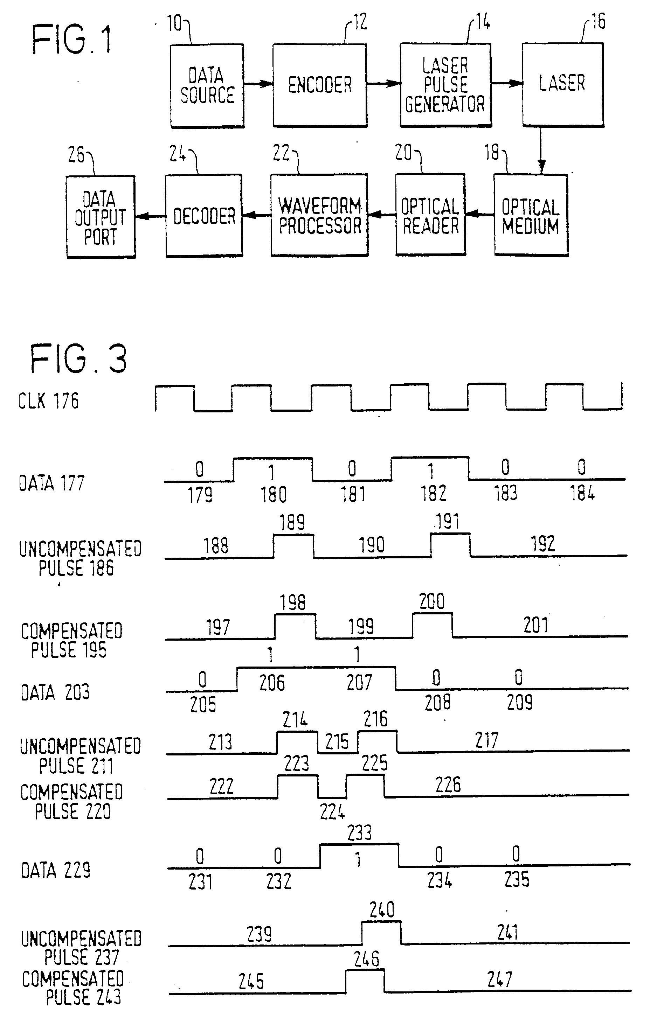

For reading data on a disk, a focused laser beam is directed at the recording surface of a rotating optical disk such
that the laser beam can selectively access one of a plurality of tracks on the recorded surface. The rotation of the laser beam reflected off the recorded surface is detected by means of Kerr rotation. A change in Kerr rotation to the first type represents the first binary value. A change in Kerr rotation to the second type represents the second binary value. A binary signal that represents the binary values that occur at a clock interval generated from the occurrences of the binary values and changes in rotation occurring at boundaries of the clock interval are generated.
An apparatus for recording data on an optical disk is provided. A source originates digital data at a given clock interval. A circuit converts the data to a binary signal having first and second binary values at a given clock interval and representative of the data. A pulse generator produces energising pulses having a duration less than an clock interval for converted data having the first binary value. A laser controller applies to the energising pulses to a laser to turn the focused laser beam on and off responsive to the energising pulses. A circuit directs the laser at a recording surface on a rotating optical storage device, such that the laser beam can selectively access one of a plurality of tracks on the recording surface.
An apparatus for reading data on an optical disk is provided. A circuit rotates an optical data storage disk having a recorded surface. The controller directs a laser with a focused beam at the recorded surface such that the laser beam can selectively access one of a plurality of tracks on the recorded surface. A circuit detects the rotation of the laser being reflected off the recorded surface. A decoder converts changes in rotation of a first and second type into first id second binary values, respectively. A circuit generates a binary signal that represents the binary values that occur at a clock interval generated from the occurrences of the binary values and changes in rotation at boundaries of the clock interval.
An optical data storage and retrieval system is provided with data recording and reading utilising cell boundary transition codes, special signal processing, and control of write pulses. Specifically a data encoder encodes digital data in a code where transitions occur only at cell boundaries. A cell is defined as the encoded bits that represent one data bit.
For example, in RLL2/7 bits can be recorded at the cell boundary or at the center of the cell. The detection window is +/- 25% of a cell. Preferably in this invention a pulse group code recording (GCR) 8/9 code is used. Because eight data bits are encoded into nine bits, a cell is effectively defined as one data bit. For this invention, a cell will occur at each clock interval. The detection window becomes +/-50% of the cell. Furthermore, the GCR 8/9 code allows a limited number of consecutive zeros e.g. three - even across word boundaries. This code also contains self-clocking. With certain data patterns, the timing margin can be enhanced. A monitor that looks for data sequences which match these predetermined data patterns is included. When one of these data patterns occurs, the laser is pulsed earlier, preferably by four to six nanoseconds. Under normal writing the laser is pulsed uniformly. With some data patterns an increase in effective write power creates better defined edges. A second monitor looks for these data sequences and, when one occurs, the laser will not be pulsed as it would under other data patterns.
Thus, the effective write power is increased.
To reduce the asymmetry of the rise and fall of an isolated pulse, signal processing may be performed for reshaping the read data waveform. For example, the pulse will be narrowed and amplified. The preferred embodiments differentiates the amplified read waveform. The amplified signal is summed with its derivative, resulting in a narrowed and symmetrical pulse.
For lower frequency signals, the pulse slimming will produce overshoot. Because this overshoot is predictable, the threshold of the read circuitry can be increased momentarily to prevent false data reads. A monitor will monitor the reshaped waveform and, upon the occurrence of an overshoot, the monitor will increase the threshold of the read waveform detector.
According to another feature of the invention, an optical data storage and retrieval system is provided with downward compatibility from a high-density recording format to a low-density, eg. ANSI, format. Specifically, a first write encoder encodes digital data in a first preferable high-density format. A second write encoder encodes digital in a second, e.g. ANSI, format. A first read decoder decodes digital data from the first format A second read decoder decodes digital data from the second format. A disk drive received a, e.g. 90 mm, replaceable optical disc. A read-write head reads encoder data from and write encoder data to the optical disc received by the drive. In a first mode, the first encoder is connected between a source of digital data and the read/write head, and the first decoder is connected between the read/write head and the utilising apparatus. In a second mode, the second encoder is connected between the source and the read/write head and the second decoder is connected between the read/write head and the utilising apparatus. Control electronics switch between the first and second modes, depending on the format in which data is recorded on the disc by disc drive. As a result, the system can exploit high density recording formats, while achieving downward compatibility with low-density ANSI format. Thus, data can be stored and retrieved in different formats in a single system that employs the same read/write head and disc drive.
According to yet another feature of the invention, the first and second formats are organised into sectors having the same number of bytes, there being more sectors in the first format than in the second format in accordance with the higher density. As a result, the same interface electronics can be employed to store and retrieve data in both formats.
The present invention can be put into practice in various ways, some of which will now be described by way of example with reference to the accompanying drawings in which :
Figure 1 is a block diagram showing an optical data storage and retrieval system ;
Figure 2 is a series of waveforms, a sample waveform associated with a pulsed GCR format and a pulsed RLL 2/7 format ;
Figure 3 is a series of waveforms showing laser pulsing for various data patterns adjusted by the write compensation circuit ;
Figure 4 is a schematic diagram showing the write compensation circuit ;
Figure 5 is a series of waveforms showing laser pulsing for amplitude asymmetry correction ;
Figure 6 is a schematic diagram showing the amplitude of asymmetry correction circuit ;
Figure 7 is a block diagram showing the basic relationship of elements of the pulse slimming means ; Figure 8 is a series of waveforms showing threshold adjustments by the dynamic threshold circuit ;
Figure 9 is a schematic diagram for a dynamic threshold circuit ;
Figure 10 is a schematic block diagram of an optical data storage and retrieval system incorporating downward compatibility ;
Figures 11 A and B are waveform diagrams of a symmetrical and asymmetrical input signal, respectively ;
Figure 12 is a block diagram of a read channel ;
Figure 13 is a more detailed block diagram of various stages of a read channel ;
Figure 13B is a detailed circuit diagram of a partial integrated stage ;
Figures 14A-14E are frequency response diagrams of various stages of a read channel ;
Figure 14F is a plot of a group delay for a combination of stages in a read channel ;
Figure 14G is a waveform diagram showing signal waveforms at various stages in the read channel ;
Figure 15 is a block diagram of a peak detection and tracking circuit ;
Figure 16 is a schematic diagram of the peak detection and tracking circuit of Figure 15 ;
Figure 17 is a waveform diagram showing tracking by a threshold signal of the dc envelope of an input signal ; and
Figures 18A-18D are diagrams showing exemplary waveforms at various points in the read channel. Although the present invention is applicable to many different data storage and retrieval systems, the following description of the preferred embodiment will focus on magneto-optical systems. In so doing, there is no intent to limit the scope of the invention solely to devices which are magneto-optical in nature.
A detailed system for storing and retrieving data for a magneto-optical device is provided in relation to application serial no. 07/964,518 filed January 25, 1993 which application is-incorporated by reference as is fully set forth herein.
A block diagram of an exemplary magneto-optical system is shown in Figure 1. The system may have a read and a write mode. During the write mode a data source 10 transmits data to an encoder 12. The encoder 12 converts the data into binary code bits.
The binary code bits are transmitted to a laser pulse generator 14, where the code bits may be converted to energising pulses for turning a laser 16 on and off. In one embodiment, for example, a code bit of 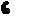 1 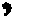 indicates that the laser will be pulsed on for a fixed duration independent of the code bit pattern, while a code bit of '1' indicates that the laser will not be pulsed at that interval. Depending on the particular laser and type of optical medium being used, performance may be enhanced by adjusting the relative occurrence of laser pulse or extending the otherwise uniform pulse duration. In response to being pulsed, the laser 16 heats localised areas of an optical medium 18, thereby exposing the localised areas of the optical medium 18 to a magnetic flux that fixes the polarity of the magnetic material on the optical medium 18. The localised areas, commonly called 'pits', store the encoded data in magnetic form until erased.
During the read mode, a laser beam or other light source is reflected off the surface of the optical medium 18. The reflected laser beam has a polarisation dependent upon the polarity of the magnetic surface of the optical medium 18. The reflected laser beam is provided to an optical reader 20, which sends an input signal or a read signal to a waveform processor 22 for conditioning the input signal and recovering the encoded data. The output of the waveform processor 22 may be provided to a decoder 24. The decoder 24 translates the encoded data back to its original form and sends the decoded data to a data output port 26 for transmission or other processing as desired.

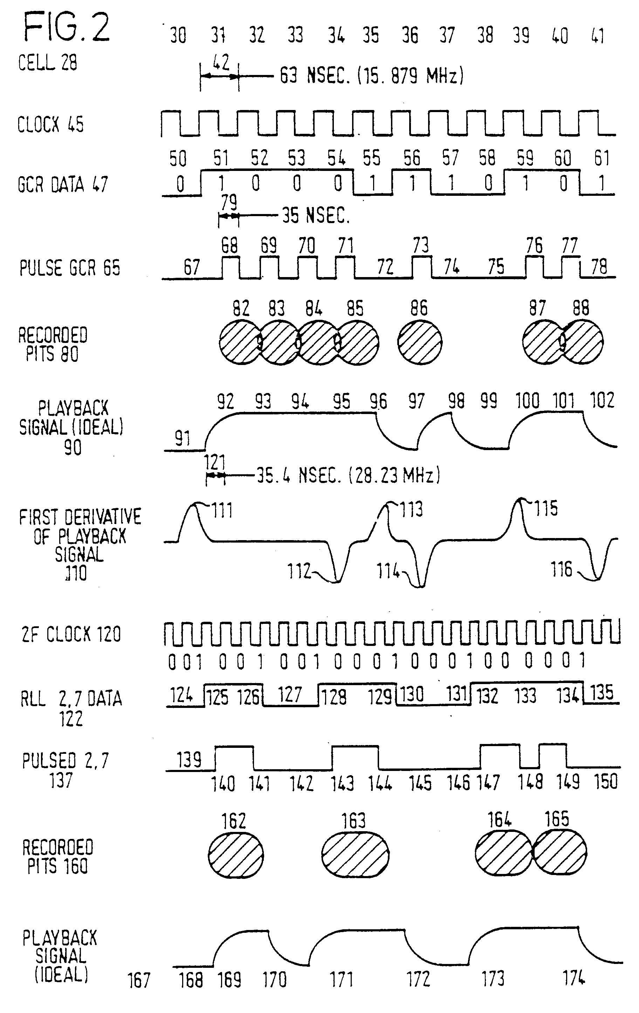

Figure 2 depicts in more detail the process of data storage and retrieval using a GCR 8/9 and an RLL 2/7 code format.
For a GCR 8/9 code, a cell 28 is defined as one channel bit. Each clock period 42 corresponds to a channel bit ; thus cells 30 through 41 each correspond to one clock period 42 of clock waveform 45. As an example of clock speeds, for a 3^{1/2} optical disc rotating at 2,400 revolutions per minute with a storage capacity of 256 Mbytes, clock period 42 will typically be 63 nanoseconds or a clock frequency of 15.879 MHz. GCR input waveform 47 is the encoded data output from the encoder 12 (see Figure 1). The GCR input waveform 47 corresponds to a representative channel sequence '010001110101'. The laser pulse generator 14 uses the GCR data waveform 47 to derive the pulse GCR waveform 65 (which in Figure 2 has not been adjusted in time or duration to reflect performance enhancement for specific data patterns). Generally the GCR pulses 67 through 78 occur at clock periods when the GCR data waveform 47 is high. The pulse GCR waveform 65 is provided to the laser 16. The magnetisation of the optical medium reverses polarity as the laser is pulsed on and off (eg. by utilising a non-return-to-zero ('NRZ') driving signal to energise a magnetic recording head). The laser pulses resulting from GCR pulses 68, 69, 70, etc. create a pattern of recorded pits 80 on optical medium 18. Thus, recorded pits 82 to 88 correspond to pulses 68, 69, 70, 71, 73, 76 and 77, respectively.
Successive recorded pits 82 through 85 may merge together effectively to create an elongate pit. The elongate pit has a leading edge corresponding to the leading edge of the first recorded pit 82 and a trailing edge corresponding to the trailing edge of last recorded pit 85.
Under the GCR 8/9 data format, a leading edge corresponds to GCR data 47 going high, and a trailing edge corresponds to GCR data 47 going low. Hence, for data pattern '1000' as shown by GCR data 51 through 55, a leading edge occurs for the first '1' (GCR data 47 going high) as shown by recorded pit 82 ; and, at the end of the GCR data 54, a trailing edge occurs as shown by recorded pit 85, because GCR data 55 is low.
Reading the recorded pits with an optical device such as a laser results in the generation of a playback signal 90. The playback signal 90 is low in the absence of any recorded pits. At the leading edge of a pit 86, playback signal 90 will rise and remain high until the flailing edge of the pit 86 is reached, at which point the playback signal 90 will decay and remain low until the next pit 87. For example, playback signal 91 is low because GCR data 50, which is low, did not create a pit. At the front edge of recorded pit 82, playback signal 90 has a leading edge as shown in playback signal 92.
Playback signal 90 will then remain unchanged until a trailing edge occurs one a recorded pit. For example, because recorded pits 83 and 84 show no trailing edge, playback signals 93 and 94 remain high. The signal remains high during playback signal 95 because of recorded pit 85. However, because GCR data 55 is low, recorded pit 85 creates a trailing edge. Thus, playback signal 96 decays. The signal will decay to '0' until a recorded pit occurs, creating a leading edge. Thus, the occurrence of recorded pit 86 which corresponds to GCR data 56 being high, playback signal 97 rises. Because there is no immediate successor to recorded pit 86 when GCR data 57 is low, playback signal 98 decays. Playback signal 99 remains low because there is no recorded pit when GCR data 58 is low. With GCR data 59 and 60 being high, recorded pits 87 and 88 overlap, creating one larger pit. Thus, playback signal rises and playback signal 101 remains high. Playback signal 102 falls at the trailing edge of recorded pit 88 when GCR data 61 is low.

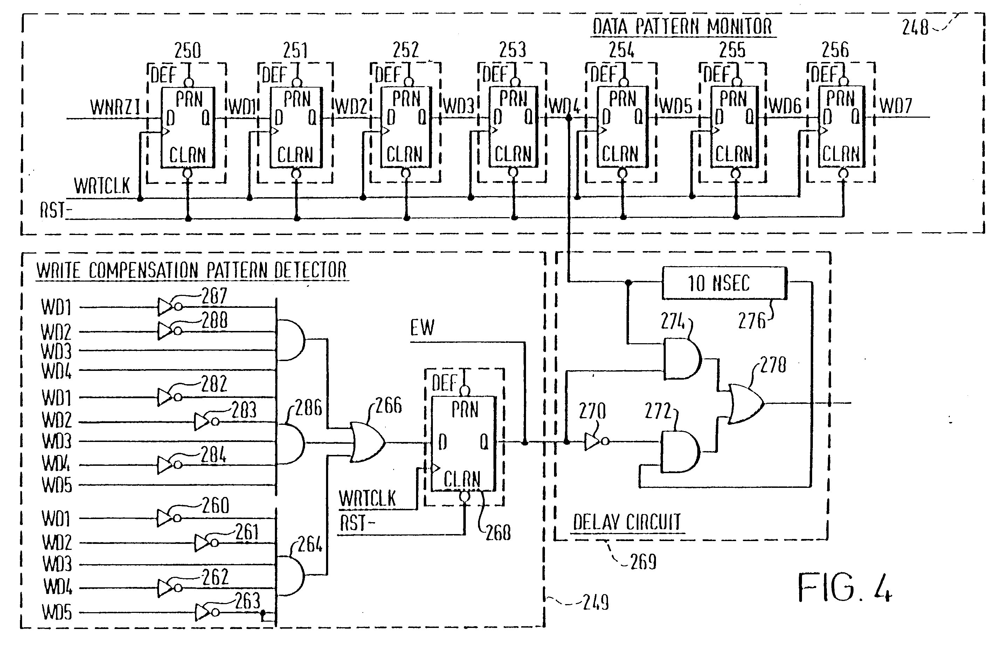

The above described process may be referred to as pulse width modulation (PWM) because the width of the pulses in playback signal 90 indicate the distance between one-bits. Thus, the edges of the recorded pits 80 which define the length of the pulses in playback signal 90 contain the pertinent data information. If the playback signal is differentiated, the signal peaks 111 through 116 of the first derivative signal 110 will correspond to the edges of the recorded pits 80. (The signal peaks of the first derivative playback signal 110 in Figure 2 are shown slightly offset from the edges of the recorded pit 80 because an ideal playback signal 90 is shown). In order to recover the pit edge information from the first derivative signal 110, it is necessary to detect the signal peaks 110 through 116. Such a process is described in detail further herein.
In contrast, most if not all existing RLL 2/7 code systems are used in conjunction with pulse position modulation ('PPM'). In PPM systems, each pit represents a '1' while the absence of a pit represents a '0'. The distance between pits represents the distance between one-bits. The centre of each pit corresponds to the location of the data. In order to find the pit centres, the playback signal is differentiated and the zero-crossings of the first derivative are detected. Such a technique may be contrasted with PWM systems, described above, in which the signal peaks of the first derivative contain the pertinent pulse width information.
It is nevertheless possible to utilise PWM instead of PPM with an RLL system such as an RLL 2/7 code system. Each channel bit may correspond to a clock period of a clock waveform. As with the GCR system described earlier using PWM, a '1' may be represented by a transition in the input waveforms. Thus, the RLL 2/7 input waveform may remain in the same state while a '0' occurs but changes from high-to-low or low-to-high when a '1' occurs.
For RLL 2/7 a cell consists of two data bits, which correspond to two clock periods 121 of 2F clock waveform 120. For a 256 Mbytes disk, RLL 2/7 encoding format will require a 2F clock pulse width 121 of 35.4 nanoseconds or a clock frequency of 28.23 MHz. The calculation of this value is straightforward. In order to maintain the same disk density the GCR 8/9 and RLL 2/7 encoding formats must contain the same amounts at information in the same recording time.
Because two code bits are required per data bit in the RLL 2/7 format, it requires a clock frequency twice that of the GCR data format. The GCR data format records nine bits of code per eight bits of data. Thus, the GCR data bit clock is 9-8ths of the clock period 42.
Thus, for a GCR clock period 42 of 63 nanoseconds, the RLL 2/7 pulse width 121 must be 35.4 nanoseconds in order to maintain the same disk density.
The RLL 2/7 data waveform 122 reflects two code bits per cell. For example, RLL 2/7 data 124 shows a data pattern '00' while RLL 2/7 data 125 shows a data pattern '10'. In this data format a '1' represents a transition in data. Thus, RLL 2/7 data 125 goes high when the '1' occurs in the data pattern. Similarly, RLL 2/7 data 126 goes low when the '1' occurs in the data pattern. While a '0' occurs, RLL 2/7 data 122 remains in the same state. Pulsed 2,7 waveform 137 reflects the pulsing of laser 16 corresponding to RLL 2/7 data 122. Thus, for RLL 2/7 data 125 and 126, during the period when that signal is high, pulsed 2,7 waveform 140 and 141 is high. Because of the thermal elongation of the pit, pulsed 2,7 waveform 141 goes low prior in time to RLL 2/7 data 126. For longer data patterns of '0', the pulsing must remain on. For example, during the data pattern '10001' as shown in RLL 2/7 data 128 and 129, pulsed 2,7 waveform 143 and 144 remain high longer than pulsed 2,7 waveform 140 and 141. For data patterns of successive '0', the pulsed 2,7 waveform 137 can be pulsed as separate pulses. For example, the data pattern '1000001', RLL 2/7 data 132, 133 and 134 can be pulsed in two separate pulses as shown in pulse 2/7 147, 148 and 149.
As with the GCR 8/9 format, recorded pits 160 show thermal elongation. For example, recorded pit 162 is wider in time than the pulse from pulsed 2,7 waveform 140 and 141 ; a similar result may be seen for recorded pit 163. Physical limitations of existing lasers and optical disks prevent recorded 163 from being recorded in two successive pulses at 2F clock 120 frequency. Thus, for these intermediate sized pits, the thermal accumulation distortion effects will be greater than in either recorded pit 162 or the combined recorded pits 164 and 165. Again, playback signal 167, depicted by playback signal 168 through 174, goes high on leading edges of recorded pits 160, decays on trailing edges of recorded pits 160, and remains constant during the presence or absence of pits.
The pulsed GCR code can be improved by correcting predictable position shift. Figure 3 shows the timing diagram for the write compensation of the laser pulse generator 14.
Experimental testing showed that recording early when the laser 16 is off for two bits or greater enhances performance. Clock waveform 176 is the code bit clock used for clocking data 177, 203 and 229, which show the worst case data patterns for enhancement. Other patterns can be corrected, but will suffer in signal amplitude. Data 180 through 184 correspond to the data sequences '10100'. The uncompensated pulse waveforms 188 through 192 correspond to this data pattern without write compensation.
Uncompensated pulse waveforms 189 and 191 occur in the second half of the clock period. After write compensation, the output of the laser pulse generator 14 corresponds to compensated pulse waveform 195, where compensated waveforms 197 and 198 remain unchanged, and a shortened off-period for compensated pulse waveform 199 provides an earlier compensated pulse waveform 200. During compensated pulse 201, laser 16 remains off for a longer duration than uncompensated pulse 192. Similarly, for data 206 through 209 corresponding to data pattern '1100', uncompensated pulse waveform 211 would be off for uncompensated pulse waveform 213 followed by two pulses, i.e. uncompensated pulse waveforms 214 and 216. Again, the write compensation circuit adjusts compensated pulse waveform 220 so that compensated pulse waveform 225 will occur closer in time to compensated pulse waveform 223 so that compensated pulse waveform 224 is shorter than uncompensated pulse waveform 215. Finally, data 231 through 235, corresponding to the data pattern '00100' have uncompensated pulse waveform 237 occurring at uncompensated pulse waveform 240.
Write compensation would move compensated pulse waveform 243 earlier in time to compensated pulse waveform 246. Figure 4 shows the schematic diagram of the write compensation circuit which comprises data pattern monitor 248, write compensation pattern detector 249 and delay circuit 269. Data pattern monitor 248 is a serial shift register that sequentially clocks encoded data from encoding means 12. The last five clocked in data bits are sent to write compensation pattern detector 249, where they are analysed for determining whether to pulse the laser earlier than normal.
Data pattern monitor 248 consists of data sequence D flip-flops 250 through 256.
Encoded data is input into the D port of data sequence D f lip-flop 250 whose Q output WD 1 becomes the input of the D port of data sequence flip-flop 251. The clocking continues through data sequence D flip-flops 252 through 256 whose Q output WD7 is the data sequence delayed by seven clock periods from it was first input into data pattern monitor 248. The Q outputs WD1, WD2, WD3, WD4 and WD5 of data sequence D flip-flops 250 through 254, respectively, represent the last five of the last seven data bits input into the data pattern monitor 248. These five bits are sent to a write compensation pattern detector 249 where they are compared to predetermined data patterns and, if they match, an enable write signal is sent to a delay circuit 269 to indicate that the laser pulse is to occur earlier than normal.
The first pattern detector is detected by inverting the Q data WD1, WD2, WD4 and WD5 from data sequence D flip-flops 250, 251, 253 and 254, respectively, though data inverters 260, 261, 262 and 263, respectively. The outputs of these inverters are AND'ed with the output from data sequence D flip-flop 252 in detect AND gate 264. Thus, when a sequence '00100' occurs the output of detect AND gate 264 goes high, indicating that a detection of the data pattern occurred. Similarly, the second data pattern is detected by inverting the Q outputs WD1, WD2 and WD4 from data sequence D flip-flops 250, 251 and 253, respectively, through the data inverters 282, 283 and 284, respectively, and AND'ing these inverted outputs with the outputs WD3 and WD5 of data sequence D flip-flops 253 and 254 in detect AND gate 286. Thus, a data pattern '010100' will trigger a high from detect AND gate 286, indicating a detection.

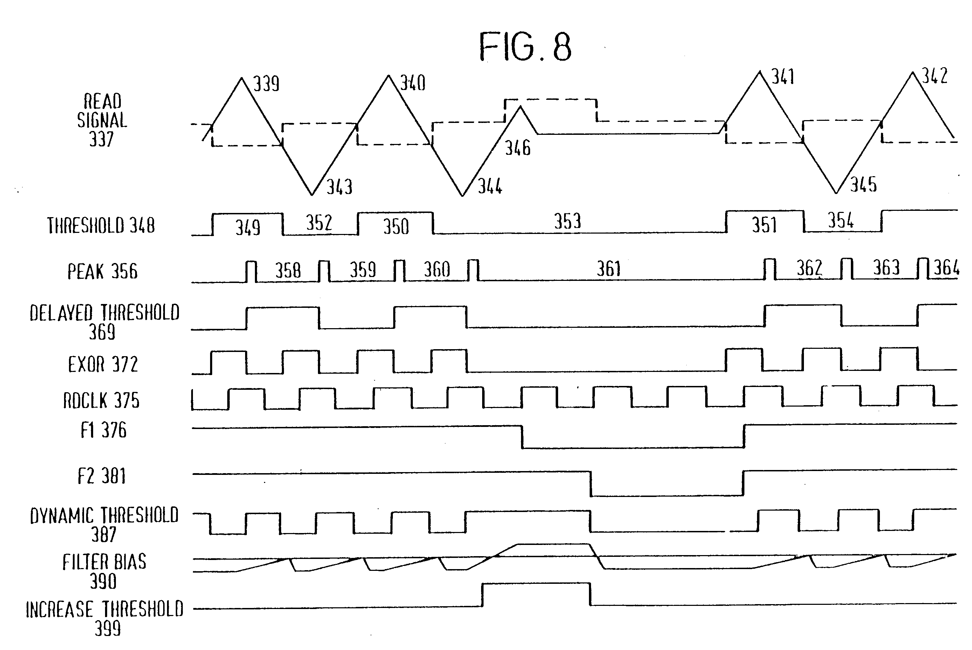

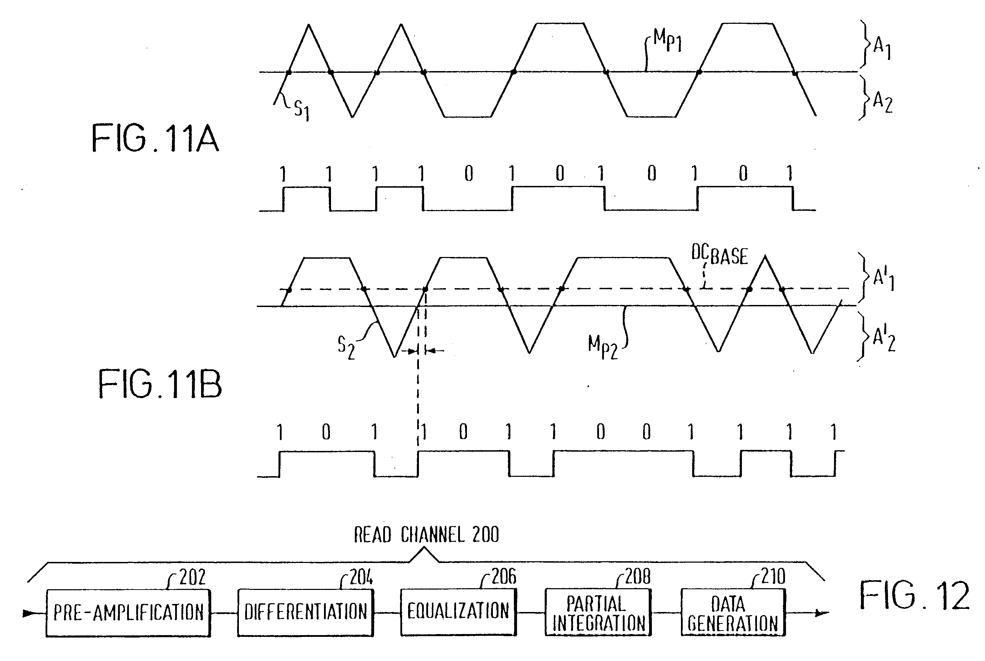

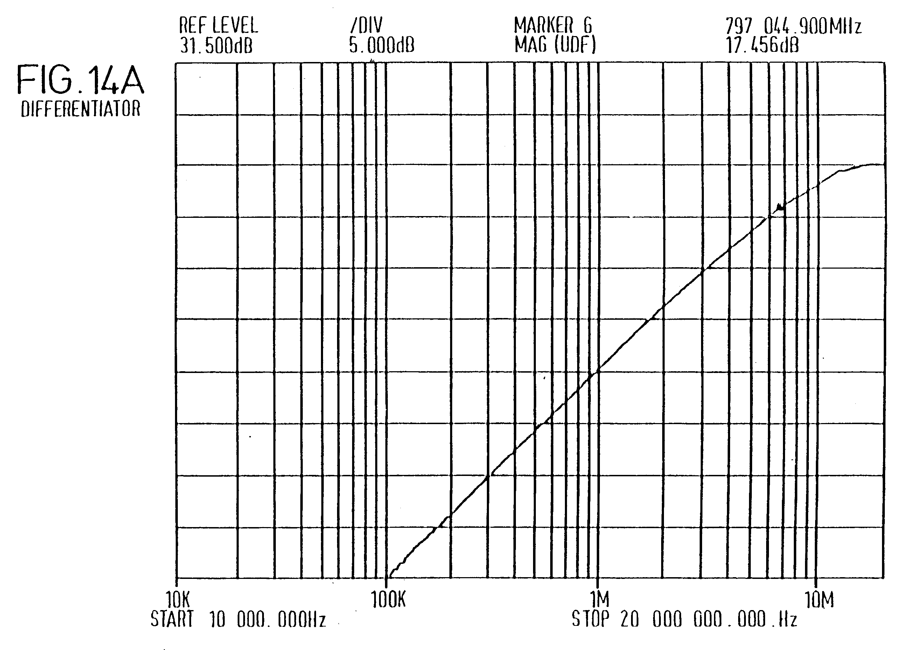

The third data sequence is detected by inverting the Q outputs WD1 and WD2 from data sequence D flip-flops 250 and 251, respectively, through data inverters 287 and 288 and AND'ing these inverted outputs with the Q outputs WD3 and WD4 from data sequence D flip-flops 253 and 254, respectively, in data detect AND gate 289. Thus, the data pattern of '1100', will trigger a detect from detect AND gate 289 indicating the presence of the data. The data pattern detect outputs of detect AND gate 264, 286 and 289 are OR'ed in detected pattern OR gate 266 whose output goes high when one of the three data patterns is detected. The detected pattern output is clocked in enable write D flip-flop 268, whose Q output, the enable write signal, is then sent to delay circuit 269.
Delay circuit 269 takes the clocked data output WD4 of data sequence D flip-flop 253 and simultaneously inputs it into delay circuit 276 and not delay-select AND gate 274.
The delayed output of delay circuit 276 is inputted into delay-select AND gate 272. The enable write signal from write compensation pattern detector 249 will enable either delay-select AND gate 272 or not-delay-select AND gate 274. When the enable write signal is low, which indicates that one of the three data patterns has not occurred, it is inverted by enable write invertor 270. This allows the delay data from delay circuit 276 to be clocked. On the other hand, if enable write is high, which indicates that one of three data patterns has occurred then the not-delay-select AND gate 274 allows the transmission of the data from the date sequence D flip-flops 253 which is undelayed.
The outputs from the delay-select AND gate 272 and not-delay-select AND gate 274 are OR'ed in data OR gate 278 where they are outputted from delay circuit 269. Although prior discussions about the write compensation circuit or timing indicated that for the three data patterns, the write pulse would occur 10 nanoseconds earlier, in actual implementation, data is delayed 10 nanoseconds for all data but the three data patterns.
The delay of delay circuit 276 is set between 8 to 12 nanoseconds for the frequency of the preferred embodiment.
When recording lower frequency data patterns, the resultant magneto-optical signal has a slower rise time than fall time. This causes the final output from the waveform processor 22 to have degraded amplitude on positive peaks, which can be corrected by recording with higher effective power at the leading edge of the data pattern. For the preferred embodiment, the data pattern '000111' will trigger a wide-write signal during the second '1' of the data pattern thereby pulsing the laser during its normal off period.

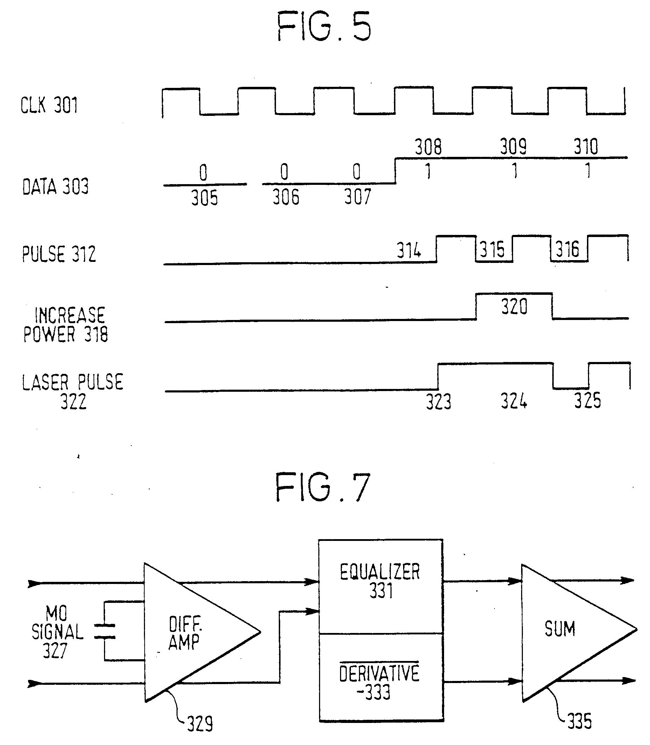

In Figure 5, clock waveform 301, clock data waveform 303 through the laser pulse generator 14 for the data pattern '000111'. As depicted by data 305 through 310, the laser pulse generator 14 generates pulse waveform 312 with pulses 314, 315 and 316 when data waveforms 303 is a '1'. During the second '1' of this data pattern, the laser pulse generator 14 will turn on for the increased power waveform 318 at increased power waveform 318 and at generated pulse 320. The output laser pulse waveform 322 results from the OR of 312 and turn on for the increased power waveform 318 that creates laser pulses 323, 324 and 325. Under normal operations, the laser pulse 324 would be off during the first half of a clock period. However, under this particular data pattern, keeping the laser on for the laser pulses 323 and 324 effectively increases the power 50% during this time period.

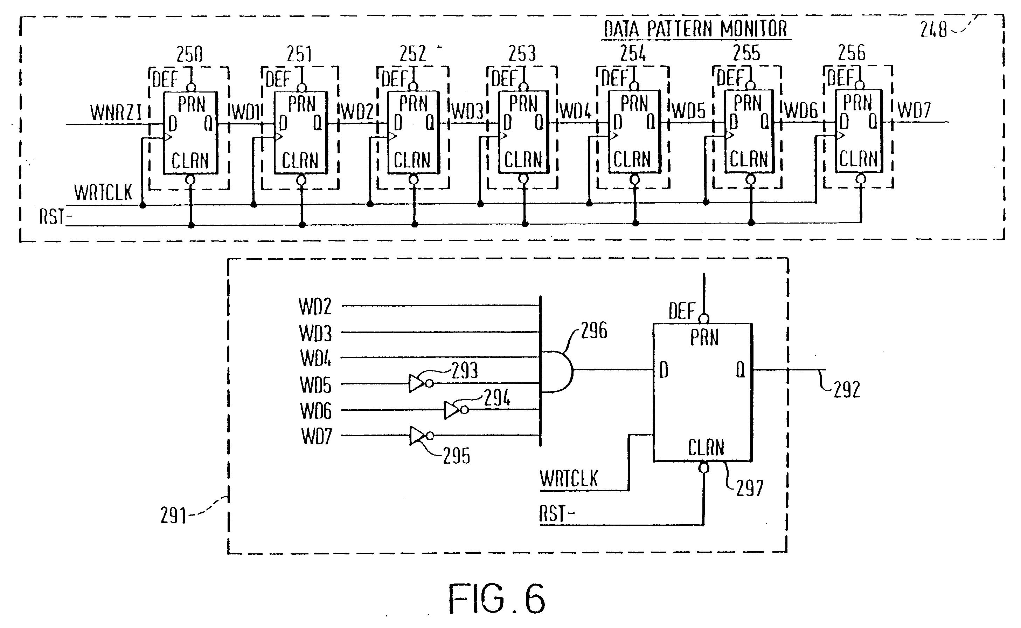

In Figure 6 amplitude asymmetry correction circuit 291 generates the write-wide pulse 292 (corresponding to increased power waveform 318 in Figure 5) which will be OR'ed with the law pulse output from delay circuit 269 (corresponding to pulse waveform 312 in Figure 5) in laser pulse OR gate 280 (Figure 4) resulting in output laser pulse waveform 322. The data pattern monitor 248 operates as shown in Figure 4. The Q outputs WD2, WD3, WD4, WD5, WD6 and WD7 of data sequence D flip-flops 251 through 256, respectively, are inputted into the amplitude asymmetry correction circuit 291 where the output WDS, WD6 and WD7 are data sequence D flip-flops 254, 255 and 256, respectively, are inverted in data inverters 293, 294 and 295, respectively. The outputs of data inverters 293, 294 and 295 and date sequence D flip-flops 251, 255 and 253 are AND'ed in detect AND gate 296. The output of detect AND gate 296 indicates a detected pattern form '000111' which will be clocked out of write-wide D flip-flop 297 at the next clock 301.
The waveform output of the optical reader 20 will be degraded as a function of frequency and data pattern. Amplitude and timing can be enhanced by processing the signal through the waveform processor 22. The asymmetry of the rise and fall times of an isolated pulse can be improved by summing an equalised, differentiated signal with its derivative. In Figure 7, magneto-optical signal 327 is differentiated by a differential amplifier 329. The differentiated signal is inputted into an equaliser 331 where it is equalised by 5dB in the preferred embodiment and the amplitude is equalised as a function of frequency. The derivative of the equalised signal is taken by a derivative processor 333 and summed with the equalised output in an adder 335. The output of the adder 335 is the read signal 337.

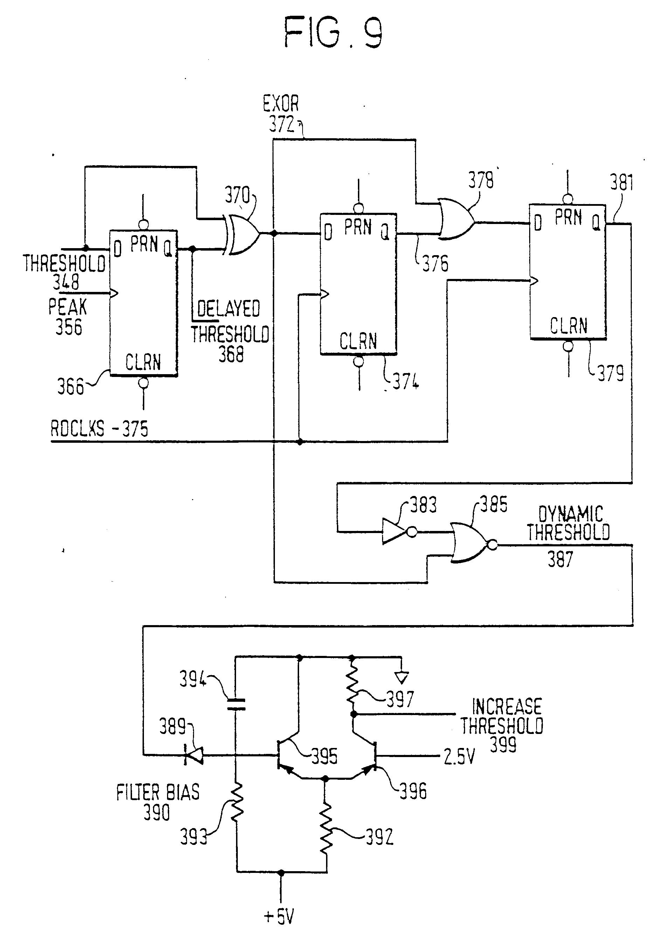

Figure 8 shows the timing diagram for the dynamic threshold circuit shown in Figure 9.Read signal 337 will contain an overshoot produced by the pulse slimming. Because this overshoot is predictable, the threshold for the read circuitry can be increased during the overshoot to prevent false data reads during positive peak 339, 340, 341 and 342, and during negative peak 343, 344 and 345 of read signal 337. Threshold waveform 348 is switched high during positive peaks. Threshold waveforms 349, 350 and 351 are high during positive peas 339, 340 and 341, respectively. Threshold waveforms 352, 353 and 354 are low during negative peak 343, 344 and 345, respectively. Each peak, whether positive or negative, of the read signal 337 generates peak waveforms 356, which is a short clocking pulse that occurs shortly after the read signal 337 peaks. Peak 339, 343, 340, 344, 341, 345 and 342 of read signal 337 generate peak waveforms 358 through 364, respectively.
As shown in Figure 9, threshold waveform 348 is inputted into the D port of threshold delay D flip-flop 366. Peak waveform 356 clock threshold waveform 348 through this flip-flop. Delayed threshold waveform 368 is the Q output of threshold delay D flip-flop 366 which is exclusively OR'ed with threshold waveform 348 in threshold exclusive OR gate 370. The EXOR signal 372 is the output of threshold-exclusive OR gate 370. The EXOR signal 372 has twice the frequency of the original threshold waveform 348. The EXOR signal 372 is inputted into the D port of EXOR D flip-flop 374 where it is clocked at read clock 375. F1 waveform 376 is the Q output of EXOR D flip-flop 374.
Read clock waveform 375 has a leading edge during high pulses of EXOR signals 372 except when EXOR signal 372 is low for more than one read clock waveform 375.
Thus, the F1 waveform 376 is high except for the time between the first read clock 375 pulse alter the EXOR signal 372 is low for more than one read clock 375 and the next EXOR signal 372 pulse.
F1 waveform 376 is OR'ed with the EXOR signal 372 in envelope OR gate 378. The output of envelope OR gate 378 is high except for the time from the first read clock 375 alter the EXOR signal 372 has been low for more than one clock period until the signal 372 goes high again. The output of envelope OR gate 378 is clocked through the D input of envelope D flip-flop 379 which is clocked by read clock 375. The Q output of the envelope D flip-flop 379 is F2 waveform 381. The F2 waveform 381 is high except from the second read clock 375 period alter the EXOR signal 372 goes low until the next read clock 375 clocks a high for the EXOR signal 372. The F2 waveform 381 is inverted through the F2 invertor 383 and NOR'ed with the EXOR signal 372 in dynamic threshold NOR gate 385 to produce the dynamic threshold waveform 387. The dynamic threshold waveform 387 is high any time the EXOR signal 372 is low, except when the F2 waveform 381 is low. Thus, the dynamic threshold waveform 387 has an on-time less than a half read clock 375 period except when the EXOR signal 372 is low on the next read clock 375 period. For this exception, the dynamic threshold waveform 387 stays high from the end of the EXOR signal 372 until the second read clock 375 pulse.
The dynamic threshold waveform 387 is used to forward or reverse bias a biasing diode 387. When dynamic threshold 387 is high, biasing diode 389 is reversed biased.
Conversely, when the dynamic threshold waveform 387 is low, the biasing diode 389 is forward biased.
When the dynamic threshold waveform 387 forward biasses the biasing diode 389 (ie. is low) the potential of the filter bias signal 390 is higher by the junction voltage of the biasing diode 389. This potential is 0.6 volt for standard devices. The 5 volt supply voltage drops across the limiting resistor 393 to the potential of the filter bias signal 390, because the voltage across the charging capacitor 394 is the difference between the filter bias signal 390 and ground. The charging capacitor 394 charges up to this potential, which is also the base voltage of a transistor 395. This turns on the transistor 395, causing the voltage drop across the limiting resistor 392 to be almost 5 volts.
Because the emitters of the transistor 395 and 396 are connected, the emitter voltage of the transistor 396 is less than the 2.5 volt base voltage of the transistor 396.
Accordingly, the transistor 396 is off so that the collector voltage across the collector resistor 397 produces an increase threshold waveform 399 which is low. The increased threshold waveform 399 is the signal that increases the threshold of the read signal 377 detector during the periods of overshoot.
When the dynamic threshold waveform 387 is high, the biasing diode 389 is reversed biased, thereby no longer grounding the base of the transistor 395. When the dynamic threshold waveform 387 goes high, the charging capacitor 394 starts charging, creating a potential at the base of the transistor 395 that will rise exponentially up to the supply voltage of 5 volts. As the filter bias signal 390 rises in voltage, the voltage at the emitter of the transistor 395 increases which equally increases the emitter voltage of the transistor 396. When this emitter voltage exceeds the base voltage by the junction potential across the emitter-to-base junction, the transistor 396 is turned on. Turning on the transistor 396 causes the increase threshold waveform 399 to go high.
Under normal operations, the dynamic threshold waveform 387 is pulsed as described above. During normal read signals, the dynamic threshold 387 is on for a period equivalent to the on period of read clock 375. The charge time for the voltage across the charging capacitor 394 to exceed the base voltage of 2.5 volts is longer than this half clock period. Thus, under normal circumstances the increase threshold waveform 399 remains low. However, during periods of overshoot, the dynamic threshold waveform 399 is on for a longer period, thereby allowing the charging capacitor 394 to charge to a voltage that exceeds 2.5 volts, thereby triggering the increased threshold waveform 399 to go high.

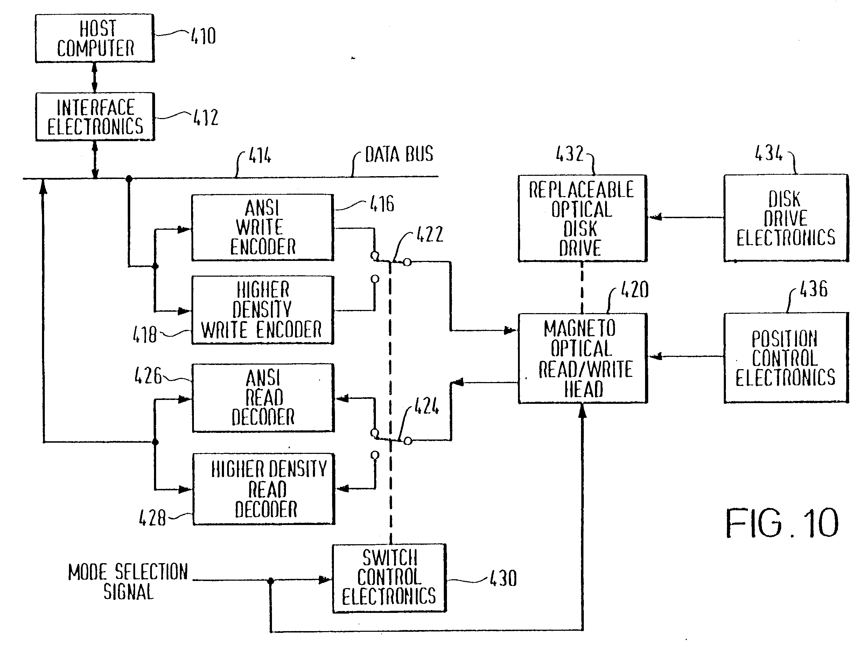

In Figure 10 a host computer 410, which serves as a source and utiliser of digital data, is coupled by interface electronics 412 to a data bus 414. As host computer 410 processes data, and it wants to access external memory from time to time, a connection is established through interface electronics 412 to data bus 414. Data bus 414 is coupled to the input of a writing encoder 416 and the input of a write encoder 418. Preferably, write encoder 416 encodes data from DOS 414 in a low-density (ie. ANSI) format ; and write encoder 418 encodes data from data bus 414 in a higher density format. The 'Draft Proposal for 90MM Rewriteable Optical Disk Cartridges for Information Interchange', dated 1^{st} January 1991, which describes the ANSI format, is incorporated herein by reference. The outputs of write encoders 416 and 418 are coupled alternatively through a switch 422 to the write input of a magneto-optical read/write head 420. The read output of head 420 is coupled alternatively through a switch 424 to the inputs of a read decoder 426 and a read decoder 428. Read decoder 426 decodes data in the same format ie. ANSI, as write encoder 416 ; and read decoder 428 decodes in the same format as write encoder 418. Preferably, the encoding and decoding technique disclosed above is employed to implement write encoder 418 and read decoder 428. The outputs of decoders 426 and 428 are connected to data bus 414.
Responsive to a mode-selection switch, switch-control electronics 430 set the states of switches 422 and 424 into either a first mode or a second mode. In the first mode, write encoder 418 and read decoder 428 are connected between data bus 414 and read write head 420. In the second mode, write encoder 416 and read decoder 426 are connected between data bus 414 and read/write head 420. Read/write head 420 reads encoder code from and writes encoded data to a 90 mm optical disk received by a replaceable optical disk drive 432, which is controlled by disk-drive electronics 434. Read-write head 420 is transported radially across the surface of the disk received by disk drive 432 by position electronics 436.
When a 90 mm disk in a high-density format is received by disk drive 432, a mode-selection signal sets the system in the first mode. As a result, data from host computer 410, to be stored on the disc, is organised by interface electronics 412 and encoded by write encoder 418 ; data read from the disk is decoded by read decoder 428, reorganised by interface electronics 412 and transmitted to host computer 410 for processing.
When a 90 mm disk in the low-density, ANSI format is received by disk drive 432, a mode-selection signal sets the system in the second mode. As a result from the host computer 410, to be stored on the disk, is organised by interface electronics 412 and decoded by write encoder 416 ; data read from the disk is decoded by read decoder 426, reorganised by interface electronics 412 and transmitted to host computer 410 for processing.
Preferably, irrespective of the format used to store the data, the mode-selection signal is stored on each and every, disk in one format, e.g. the low-density ANSI format, and the system defaults to the corresponding mode, e.g. the second mode. The mode-selection signal could be recorded in the control track zone in ANSI format. When a disk is installed in disk drive 432, disk-drive electronics 434 initially control position-control electronics 436 to read the data of the disk on which the mode-selection signal is stored.
Read decoder 426 reproduces the mode-selection signal, which is applied to switch control electronics 430. If the installed disk has the low-density ANSI format, then the system remains in the second mode when the mode-selection signal is read. If the installed disk has the high-density format, then the system switches to the first mode when the mode-selection signal is read.
In certain cases, it may be desirable to modify the laser for the first and second modes.
For example, different laser frequencies could be used or different laser-focusing lens systems could be used for the different modes. In such cases, the mode-selection signal is also coupled to read-write head 420 to control the conversion between frequencies or optical-lens focusing systems as the case may be. It is preferable to organise the data stored in both formats to have the same bytes per sector, i.e. in the case of ANSI-512 bytes. In such a case, the same interface electronics 412 can be used to organise the data stored and retrieved from the disks in both formats.
In accordance with the invention the same read-write head 420, position-control electronics 436, optical disk drive 432, disk drive electronics 434, interface electronics 412 and data bus 414 can be employed to store data on and retrieve data from optical disks in different formats. As a result downward compatibility from higher-density formats that have been developed as the state of the art advances, to the industry standard ANSI format can be realised using the same equipment.
Referring back to Figures 1 and 2, in both RLL and GCR codes, as well as other codes, when data patterns are read, the input signal generated from the optical reader 20 is not symmetrical, and the asymmetrical signal is accoupled between circuits, the average dc value shifts from the peak-to-peak midpoint. The unintentional shifting away from the midpoint may result in a shift in the apparent position of the data, adversely affecting the ability to determine accurately the locations of data and reducing timing margins or rendering the recorded data unrecoverable.
This phenomenon may be explained with reference to Figures 11 A & B. Figure 11 A shows an ideal input signal S₁ derived from a symmetrical data pattern. Normally, transitions between 1's and 0's in the data are detected at the midpoint between high and low peaks of the input signal. It may be observed in Figure 11 A that the areas A₁ and A₂ above and below the peak-to-peak midpoint Mp₁ of the input signal S₁ are equal, and the transitions between 1's and 0's correspond precisely (in an ideal system) to the crossings of the input signal S₁ and the peak-to-peak midpoint Mp₁.
Figure 11B, in contrast, shows an input signal S₂ derived from an asymmetrical data pattern. It may be observed that the area A'₁, above the peak-to-peak midpoint MP₂ is greater than the area A'2. The input signal S₂ therefore has a dc component that shifts the dc baseline DC_{BASE} above the peak-to-peak midpoint MP₂ When an attempt is made to locate transitions between 1's and 0's by determining the zero-crossings of the input signal S₂ errors may be made because the dC level is not identical to the peak-to-peak midpoint MP₂. The do level does not stay constant but rises and falls depending on the nature of the input signal. The larger the dc build up, the more the detected transitions will stray from the true transition points. Thus, dc build up can cause timing margins to shrink or the data to be unrecoverable.

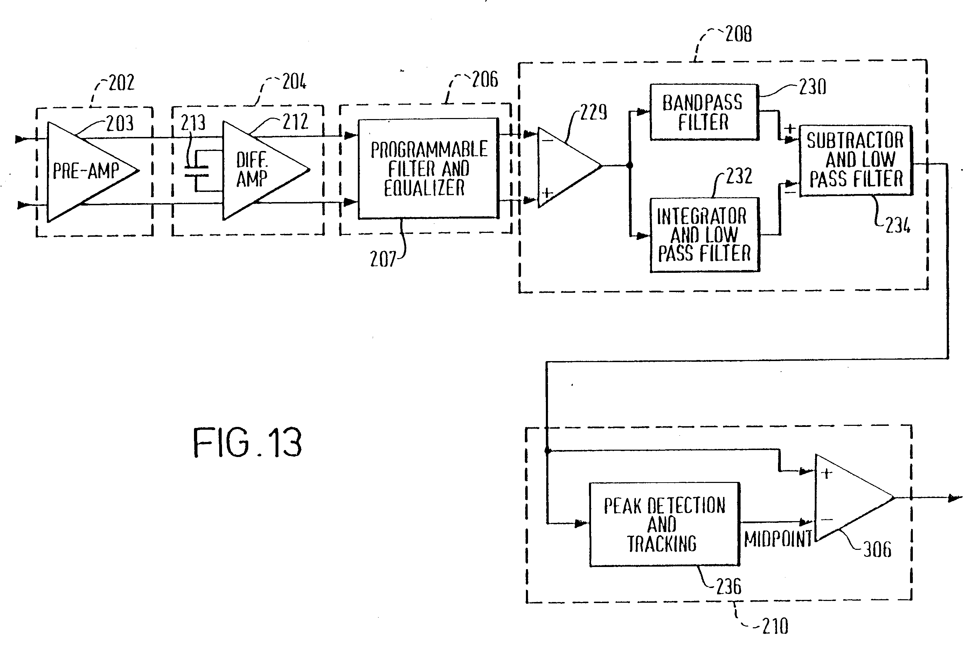

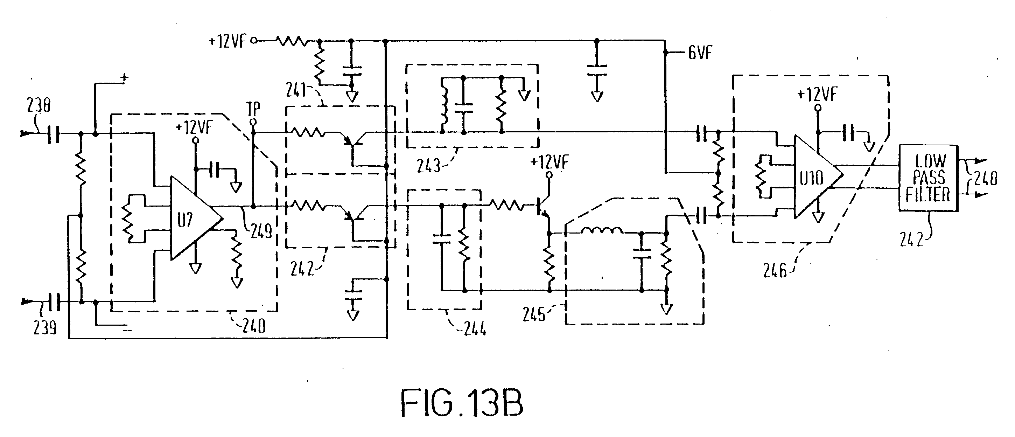

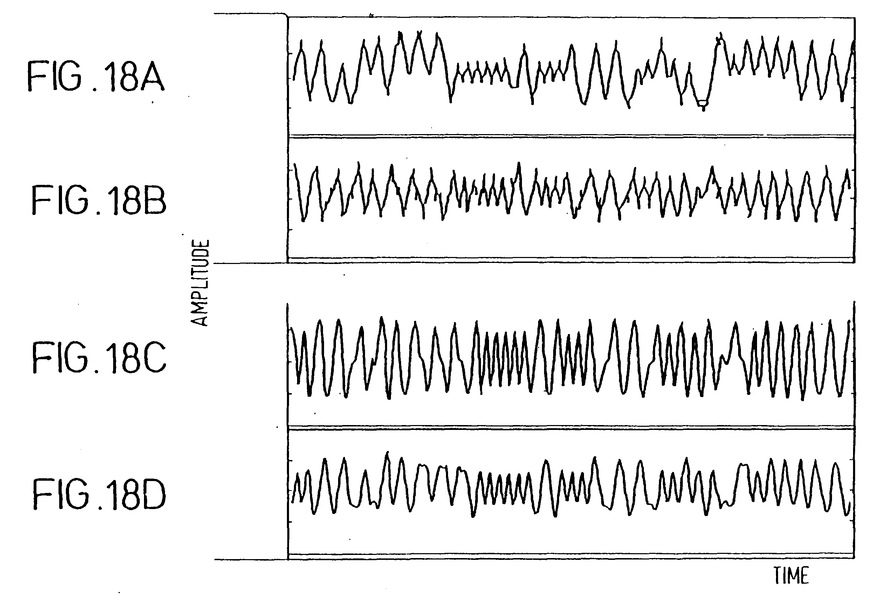

Figure 12 is a block diagram of a read channel 200 in accordance with one embodiment of the present invention for mitigating the effects of dc build up. The read channel 200 roughly corresponds to the waveform processor 22 of Figure 1. The read channel 200 comprises a preamplification stage 202, a differentiation stage 204, and an equalisation stage 206, a partial integration stage 208 and a data generation stage 210. The operation of the read channel 200 will be explained with reference to a more detailed block diagram shown in Figure 13, the waveform diagram shown in Figures 18A, 18B and various other figures as will be referenced from time to time herein.
When the optical medium is scanned for data, the pre-amplification stage 202 amplifies the input signal to an appropriate level. The pre-amplification stage 202 may comprise a pre-amplifier 203 as is well known in the art. The pre-amplifier 203 may alternatively be located elsewhere such as within the optical reader 20. An exemplary amplified play-back signal 220 is depicted in Fig. 18A.
The output of the preamplification circuit 202, as shown in Fig. 13, is provided to the differentiation stage 204. The differentiation stage 204 may comprise a differential amplifier 212 such as a video differential amplifier configured with a capacitor 213 in a manner well known in the art. A representative frequency response diagram of the differentiation stage 204 is shown in Fig. 14A. The differentiation stage 204 effectively increases the relative magnitudes of the high frequency components of the amplified playback signal 220. An exemplary waveform of the output of the differentiation stage 204 is shown in Fig. 18B.
The differentiation stage 204 is followed by an equalization stage 206 as shown in Fig. 13. The equalization stage 206 provides additional filtering so as to modify the overall channel transfer function and provide more reliable data detection. The equalization stage 206 shapes the differentiated input signal so as to even out the amplitudes of high and low frequency components and generate a smoother signal for later processing.
Equalizing filters often modify the noise spectrum as well as the signal. Thus, an improvement in the shape of the differentiated input signal (i. e., a reduction in distortion) is usually accompanied by a degradation in the signal-to-noise ratio.
Consequently, design of the equalization stage 206 involves a compromise between attempting to minimize noise and providing a distortion-free signal at an acceptable hardware cost. In general, equalizer design depends on the amount of intersymbol interference to be compensated, the modulation code, the data recovery technique to be used, the signal-to-noise ratio, and the noise spectrum shape.
A substantial portion of linear intersymbol interference when reading stored data in a magneto-optical recording system is caused by limited bandwidth of the analog read channel and roll-off of input signal amplitude with increased storage density.
Accordingly, the equalization stage 206 may comprise one or more linear filters which modify the read channel transfer function so as to provide more reliable data detection.
Normally, the equalization stage is implemented as part of the read channel, but, under certain conditions, part of the equalization filtering can be implemented as part of the write channel as well.

For purposes of analysis, the-playback-signal can be considered as a series of bipolar rectangular pulses having unit amplitude and a duration T. Alternatively, the playback signal may be considered as a series of bi-directional step functions at each flux reversal location, where the step amplitude matches the pulse amplitude. When an input signal is applied to the equalization stage 206, clocking information as well as pulse polarity for each clock cell or binit may be derived from the output signal of the equalization stage 206. The clocking and polarity information may be derived, in theory, by use of an ideal waveform restoration equalizer, which produces an output signal having mid-binit and boundary values similar to those of the input signal. The zero crossings of the output signal occur at binit boundaries in order to regenerate a clock accurately. If the zero-crossing time and direction are known, both clock and data can be extracted from the signal zero crossings.
In one embodiment. the equalization stage 206 comprises an equalizer selected from a class of waveform restoration equalizers. Generally, a waveform restoration equalizer generates a signal comprising a binary sequence resembling the input or playback waveform. The comers of the otherwise rectangular pulses of the resultant signal are rounded because signal harmonics are attenuated in the channel. The resultant signal may also exhibit some output signal amplitude variation.
An equalizer which produces a minimum bandwidth output signal is an ideal low pass filter with response of unity to the minimum cutoff frequency and no response at higher frequencies. Although such an ideal low pass filter is not physically realizable, the Nyquist theorem on vestigial symmetry suggests that the sharp cutoff minimum bandwidth filter can be modified and still retain output pulse zero crossing at all mid-binit cell times. To achieve this result, the high frequency roll-off of the equalized channel is preferably symmetrical and locates the half-amplitude point at the minimum bandwidth filter cutoff frequency.
One type of roll-off characteristic that may be exhibited by a filter in the equalization stage 206 is a raised cosine roll-off, leading to the name raised cosine equalizer. A raised cosine roll-off transfer function is approximately realizable, and has an improved response over the minimum bandwidth filter. The output pulses have a zero value at times nT, but the sidelobe damped oscillation amplitude is reduced. The output zero crossings of the raised cosine filter are more consistent than those of the minimum bandwidth filter, and linear phase characteristics are more easily achieved with a gradual roll-off, such as with the relatively gradual roil-off of the raised cosine filter. These advantages, however, are typically obtained at the expense of increased bandwidth. The ratio-of bandwidth extension to the minimum bandwidth, fm, is sometimes referred to as the *"*α*"* of the raised cosine channel. Thus, in the case of a modulation code with d = 0, a = 0 is the minimum bandwidth but represents an unrealizable rectangular transfer function, while α = 1 represents a filter using twice the minimum bandwidth.
The impulse transfer function of the raised cosine equalization channel (including the analog channel plus equalizer, but excluding the input filter may be given as follows:$\begin{matrix}\begin{matrix}\text{H(f)=1, for 0 < f < (1 -α) * fm} \\ \text{H(f) = 1/2 {1 + cos [(f- (1-α)*fm)/(2*α*fm)]}, for (1 - α)*} \text{fm} \text{< f < (1 + α)*fm} \\ \text{H(f) = 0, for f > (1 + α)*fm}\end{matrix}\end{matrix}$ where $\text{F(f) = k * f}$ is the phase, and k is a constant. The above family may be referred to as α waveform restoration equalizers. The α = 1 channel has the property of having nulls at half-binit intervals as well as at full binit intervals. Such a channel results in a signal having no intersymbol interference at mid-binit or binit boundary times, which are signal zero crossing and sample times, thus allowing accurate clock and data recovery. For such a full bandwidth equalizer, the roll-off starts at zero frequency and extends to the cutoff frequency f_{c}.
Raised cosine equalizers are capable of correcting extensive amounts of linear intersymbol interference given adequate signal-to-noise ratio. A large amount of high frequency boost is usually required to compensate for MO-media loss and optical short wavelength low resolution. An equalizer bandwidth equal to at least twice the minimum bandwidth is preferred for elimination of linear intersymbol interference, assuming a physically realizable channel operating on a modulation code with d = 0. A bandwidth of such a width generally results in reduction of the signal-to-noise ratio. The equalizer bandwidth is selected so as to achieve to optimum compromise between interference distortion and noise. In some instances, it may be desirable to narrow the bandwidth by using an α < 1 transfer function in order to improve noise at the expense of added distortion in the form of clock jitter.

Another waveform-restoration equalizer is known as the cosine β response equalizer.
The impulse transfer function of a full bandwidth β channel is as follows:$\begin{matrix}\begin{matrix}{\text{H(f)=cos}}^{\text{β}} {\text{(π*f/(2*f}}_{\text{c}} {\text{)), for 0 < f < f}}_{\text{c}} \\ {\text{H(f)=0, for f > f}}_{\text{c}}\end{matrix}\end{matrix}$

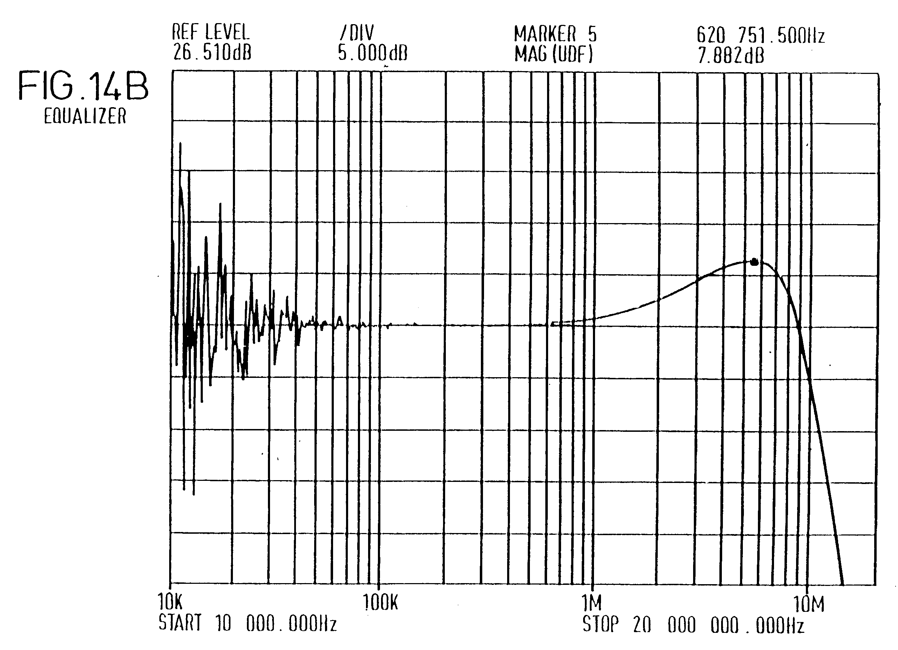

Like the α equalizer family, there are numerous β equalizers. Full bandwidth β equalizers have a cutoff frequency of f_{c}, and consequently reduce clock jitter due to the relatively small amount of interference at binit boundaries. Techniques are known in the art for optimizing these types of equalizing filters to achieve the minimum probability of error in various types of noise conditions.
Use of α equalizers generally results in a narrower band-width, thereby reducing noise at the expense of clock jitter or horizontal eye opening. Use of a β equalizer generally results in signal-to-noise ratio improvement by reducing high frequency boost without reducing the bandwidth. The choice of β equalizer may reduce the vertical eye opening or an effective amplitude reduction. The α = 1 and β = 2 equalizer channels are identical from the standpoint of eye pattern, both types of channels having a relatively wide open eye pattern.
A preferred equalizer channel bandwidth for codes with d > 0 does not necessarily depend on the minimum recorded pulse width, Tr, as might be expected, but rather on the binit width, Tm. This is because the data-recovery circuits are generally required to distinguish between pulses that differ by as little as one binit width, and time resolution is a function of signal bandwidth. The (0,k) codes (where k represents the maximum number of contiguous binits without flux reversals) require a nominal bandwidth ${\text{BM}}_{\text{NOM}} {\text{= 1/ Tm = f}}_{\text{c}}$ , so as to eliminate interference at the center and edge of each binit, provided that intersymbol interference at binit boundaries is absent.
For codes with d > 0, interference can be essentially eliminated at binit edges with a reduced bandwidth of ${\text{BW = 1/(2*Tm) = f}}_{\text{c}} \text{/2}$. In such a case, all binit read pulses then have unit amplitude at a flux reversal, and the read pulse tails cross zero at flux transitions. The narrower bandwidth BW results in output signal zero crossings at a point of no interference, without considering binit centers, but the bandwidth reduction is typically obtained with an increase in detection ambiguity in the presence of channel impairments. The narrower bandwidth BW may also result in a reduction of the signal zero-crossing slope, leading to a potential increase in detection sensitivity with respect to noise, disk speed variations, analog channel differences, or improper equalization.
For example, a half-bandwidth β = 2 equalization channel with a (1,k)2/3 rate modulation code may result in a signal having no intersymbol interference at the signal zero crossings, but some amplitude variation between zero crossings. The bandwidth is less than the bandwidth for non-return to zero ("NRZI") modulation, even though more information is recorded than with NRZI modulation (e.g., bandwidth = 0.75 and bit rate 1.33 relative to NRZI). The reduced bandwidth makes up for the modulation code rate loss. The α = 1 and α waveform restoration equalizers may permit output zero crossings to occur at the equivalent of input pulse edges. Data detection can then be obtained by hard-limiting the equalized signal, generally resulting in an output signal resembling the original playback signal. However, this result occurs only if the equalizer response extends to DC, which is typically not the case for a magneto-optical channel. Low frequency loss in the MO channel causes drift up and down of the DC baseline, resulting in output binits which are lengthened or shortened according to the degree of amplitude offset at zero-crossing detector. This problem can be reduced by the use of either a DC-free modulation code or, preferably, DC restoration as described herein. In order to achieve the desired low frequency response for a waveform-restoration equalizer, the low frequency signals may have to be amplified significantly, which can seriously degrade signal-to-noise ratio under some conditions. If low frequency noise is present in significant amounts, waveform restoration equalization techniques may not be very satisfactory unless a modulation code with no DC and little low-frequency content or DC restoration circuits are used.
In a preferred embodiment, the equalization stage 206 may comprise a programmable filter and equalizer 207 located on an integrated chip. Such integrated chips are presently available from various manufacturers. The filter and equalizer 207 maybe of an equi-ripple variety and have relatively constant group delay up to a frequency equal to about twice the cutoff frequency. A representative frequency response diagram of the equalization stage 204 is shown in Fig.14B, and an exemplary output waveform is shown in Fig. 18C.

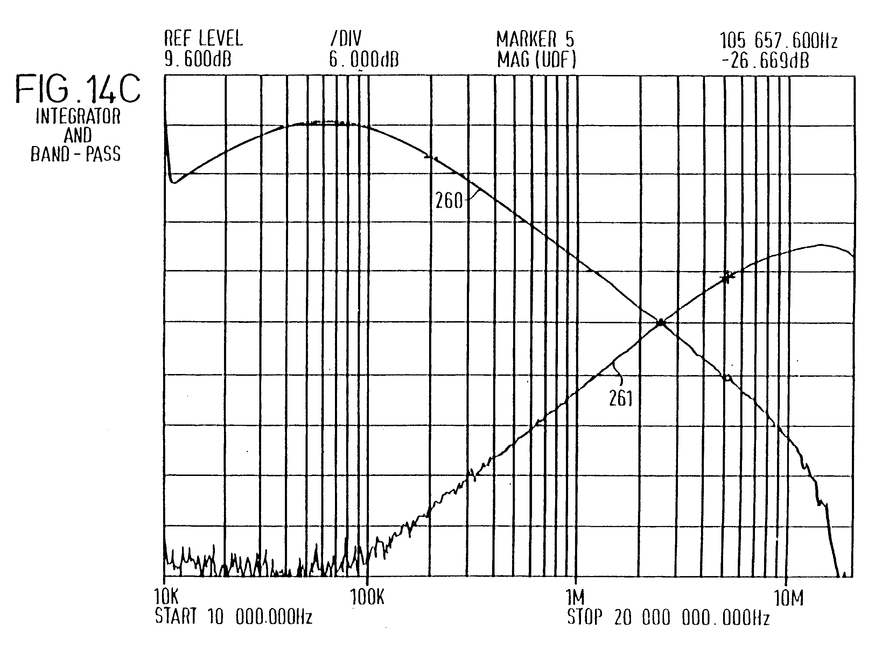

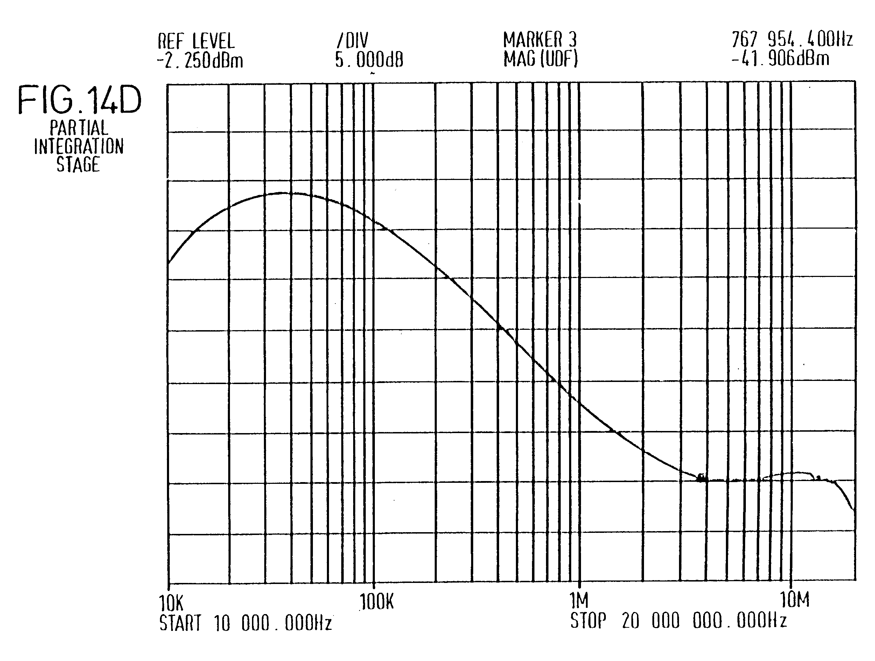

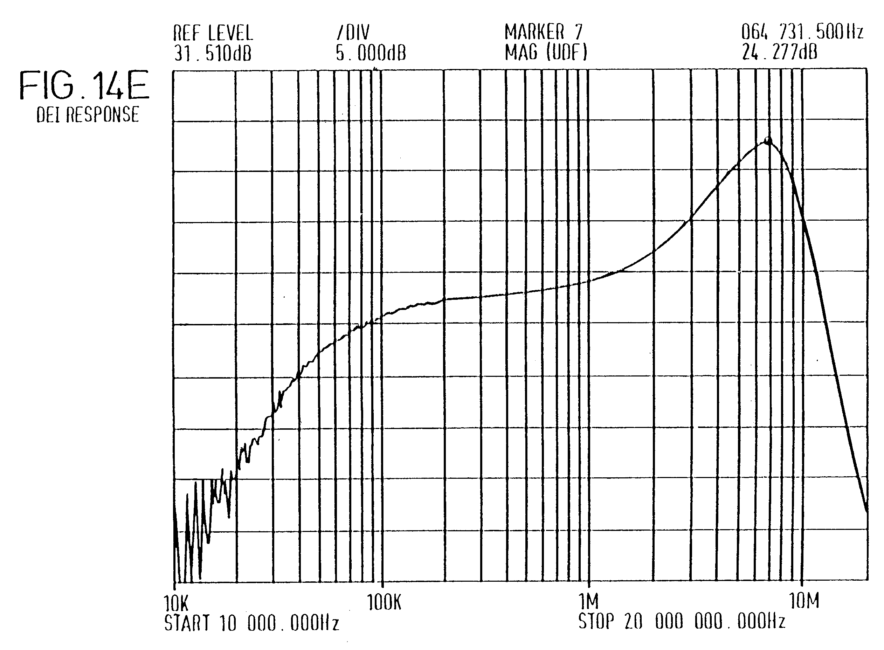

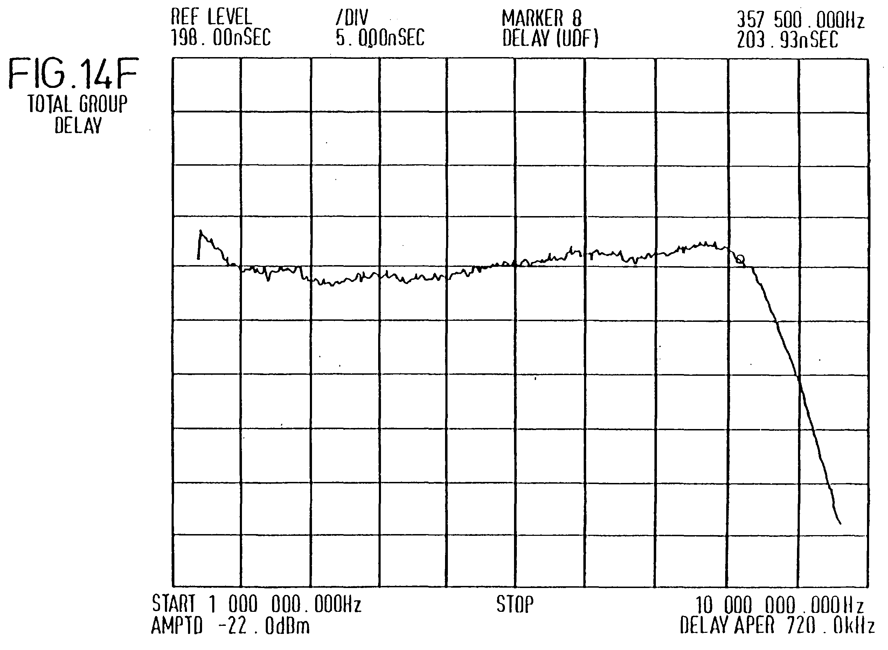

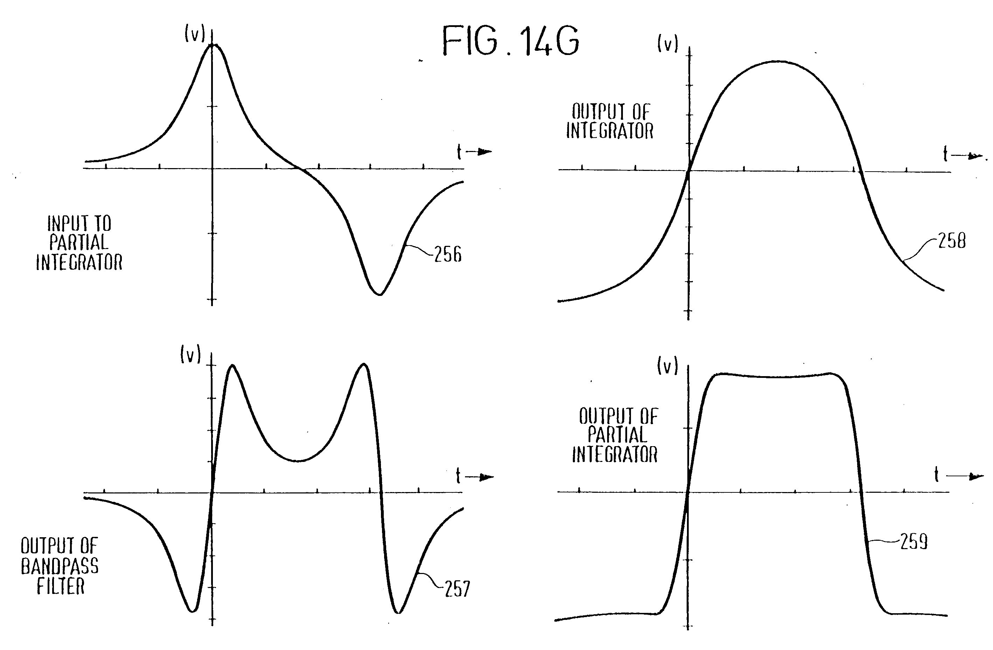

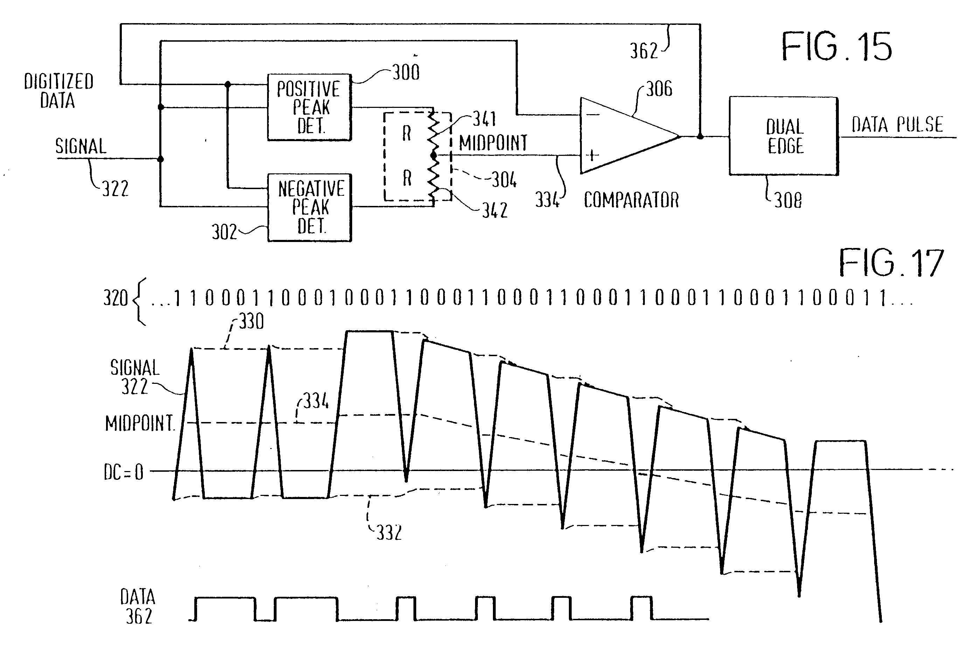

After the signal has been processed by the equalization stage 206, the signal peaks of the waveform in Fig. 18C contain accurate information regarding the position of the read data. The signal peaks can be detected by taking another derivative, but doing so may be detrimental to the system's signal-to-noise ratio and will likely cause undesired jitter. A preferred embodiment of the invention described herein provides an accurate means for detecting the signal peaks without taking a second derivative, by using partial integration and a novel data generation circuit.
After the signal has been processed by the equalization stage 206, it is provided to a partial integrator stage 208 for further shaping of the waveform. As illustrated in Fig. 13, the partial integrator stage 208 may comprise an amplifier stage 229, a bandpass filter stage 230, an integrator and low pass filter stage 232, and a substracter and low pass filter stage 234. The amplifier stage 229 receives the output of the equalization stage 206 and provides a signal to the band-pass filter stage 230 and the integrator and low pass filter stage 232. The integrator and low pass filter stage 232 preferably attenuates a selected range of high frequency components. A representative frequency response 260 of the integrator and low pass filter stage 232 and a representative frequency response 261 of the bandpass filter stage 230 are depicted in Fig. 14C.
The output of the bandpass filter stage 230 is thereafter subtracted from the output of the integrator and low pass filterstage 232 and filtered by the lowpass filter stage 234. A graph of the total frequency response of the partial integrator stage 208, including the low pass filter 234, is shown in Fig. 14D. An exemplary output waveform of the partial integrator stage 208 is shown in Fig. 18D.
A detailed circuit diagram of a particular embodiment of a partial integrator stage is illustrated in Fig. 13B. In Fig. 13B, a differential input 238, 239 is received, such as from the equalization stage 206. The differential input 238, 239 is provided to differential amplifier 240, configured as shown, which differentially sums its inputs.
Differential amplifier 240 essentially corresponds to amplifier stage 229 shown in Fig. 13.
An output 249 from the differential amplifier 240 is connected to a pair of current generators 241 and 242. The first current generator 241 comprises a resistor, R77 and a PNP transistor Q61, configured as shown in Fig. 13B. The second current generator 242 also comprises a resistor R78 and a PNP transistor Q11 configured as shown in Fig. 13B.
An ouput from current generator 241 is connected to a bandpass filter 243. The bandpass filter 243 comprises an inductor L3, a capacitor C72 and a resistor R10, configured in parallel as shown in Fig. 13B. The bandpass filter 243 essentially corresponds to bandpass filter stage 230 of Fig. 13. An output from the other current generator 242 is connected to an integrator 244. The integrator 244 comprises a capacitor C81 and a resistor R66 configured in parallel as shown in Fig. 13B.
An output from the integrator 244 is connected through a resistor R55 to a NPN transistor Q31. Transistor Q31 is configured as an emitter-follower, providing isolation with respect to the output of the integrator 244, and acting as a voltage source. The emitter of transistor Q31 is connected to a low pass filter 245. The low pass filter 245 comprises an inductor L6, a capacitor C66 and a resistor R49, configured as shown in Fig. 13B. The integrator 244, emitter-follower including transistor Q31, and low pass filter 245 essentially correspond to the integrator and low pass filter stage 232 shown in Fig. 13. The frequency response of the integrator 244 essentially corresponds to the frequency response 260 shown in Fig. 14C, while the frequency response of the low pass filter 245 essentially corresponds to the frequency response 261 shown in Fig. 14C.
An output from the low passfilter 245 and an output from the bandpass filter 243 are coupled to a differential amplifier 246, configured as shown in Fig. 13B. Differential amplifier 246 differentially sums its input, and provides a differential output to another low passfilter 247. The differential amplifier 246 arid low pass filter, 247 correspond essentially to the substracter and low pass filter stage 234 shown in Fig. 13.
Exemplary waveforms for the circuit of Fig. 5B are shown in Fig. 14G, Figure 14G shows first an exemplary input waveform 256 as may be provided to differential amplifier 240 from, e.g., equalizer 206. The next waveform 257 in Fig. 14G corresponds to an output from the bandpass filter 243 in response to the Fig. 13B circuit receiving input waveform 256. The next waveform 258 in Fig. 14G corresponds to an output from the low pass filter 245 in response to the Fig. 13B circuit receiving input waveform 256.
Waveform 258 shows the effect of operation of the integrator 244. The function of low pass filter 245 is essentially to provide a delay so as to align the output of the bandpass filter 243 and the integrator 244 in time at the input of differential amplifier 246. Low pass filter 245 thereby matches the delays along each input leg of the differential amplifier 246 prior to differential summing.
The final waveform 259 in Fig. 14G corresponds to an output from the second low pass filter 247, after the signals output from the bandpass filter 243 and low pass filter 245 have been combined and filtered. Waveform 259 typically exhibits considerably improved resolution over the original playback signal read from the magnetic medium.
It should be noted that the partial integration functions described with respect to Figs. 13 and 13B are carried out using differential amplifiers (e.g., differential amplifiers 240 and 246), thereby providing common mode rejection or, equivalently, rejection of the DC component of the input signal 238, 239. Another feature of the embodiments shown in Figs. 13 and 13B is the relatively favorable frequency response characteristics exhibited by the partial integration stage. In particular, by combining an integrated signal with a high pass filtered signal (e.g., at substracter and low pass filter block 214 or differential amplifier 246), noise is removed from the differentiated and equalized playback signal, but while maintaining relatively rapid response time due in part to the high pass frequency boost provided by the bandpass filter.
A primary function of the combination of the differentiation stage 204, the equalization stage 206, and the partial integration stage 208 is to shape the playback signal 220 in an appropriate manner for facilitating data recovery. As can be seen by comparing figs 18A and 18D, the resultant signal shown in Fig. 18D is similar to the playback signal 220 of Fig. 18A (from which it was-derived) but differs therefrom in that the amplitudes of its high and low frequency components have been equalized and sharp noise-like characteristics removed. A graph of the total frequency response for the combination of the differentiation stage 204, the equalization stage 206, and the partial integration stage 208 is shown in Fig. 14E. A graph of the total group delay response for the same chain of elements is shown in Fig. 14F.
It may be noted that tape drive systems presently exist utilizing equalization and integration of a playback signal in order to facilitate data recovery. However, to a large degree such systems do not suffer from the problems of DC buildup because they typically utilize DC-free codes. As mentioned previously, DC-free codes have the disadvantage of being relatively low in density ratio and hence inefficient. The present invention in various embodiments allows for the use of more efficient coding systems by providing means for eliminating the effects of DC buildup without necessarily using a DC-free code.
The output of the partial integrator stage 208 (e.g., the waveform in Fig. 18D) is provided to a data generation stage 210. A block diagram of the data generation stage 210 is shown in FIG. 15. The data generation stage 210 comprises a positive peak detector 300, a negative peak detector 302, a voltage divider 304, a comparator 306, and a dual edge circuit 308. The operation of the circuit show in FIG. 15 may be explained with reference to Fig. 17. In Fig. 17, it is assumed that a recorded bit sequence 320 has been read and eventually caused to be generated, in the manner as previously described, a preprocessed signal 322 from the partial integrator stage 208. It should be noted that the pre-processed signal 322 and various other waveforms described herein have been idealized somewhat for purposes of illustration, and those skilled in the art will appreciate that the actual waveforms may vary in shape and size from those depicted in Fig. 17 and elsewhere.
The preprocessed signal 322 is fed to the positive peak detector 300 and the negative peak detector 302 which measure and track the positive and negative peaks, respectively, of the preprocessed signal 322. The positive peak output signal 330 of the positive peak detector 300 and the negative peak output signal 332 of the negative peak detector 302 are depicted in Fig. 17. The positive peak output signal 330 and the negative peak output signal 332 are averaged by a voltage divider 304, which is comprised of a pair of resistors 340 and 341. The output of voltage divider 304 is utilized as a threshold signal 334 and represents the approximate-peak-to-peak midpoint of the preprocessed signal 332. The output of the voltage divider 304 is provided to a comparator 306 which compares the divided voltage with the preprocessed signal 332.
The comparator 306 changes states when the preprocessed signal 332 crosses the threshold signal 334, indicating a transition in the read data from a 1 to 0 or a 0 to 1.
The output of comparator 306 is shown as output data waveform 362 in Fig. 17. As explained in more detail below, the output data waveform 362 is fed back to the positive peak detector 300 and negative peak detector 302 to allow tracking of the DC envelope.
The output of the comparator 306 is also provided to a dual edge circuit 350 which generates a unipolar pulse of fixed duration each time the comparator 306 changes states.

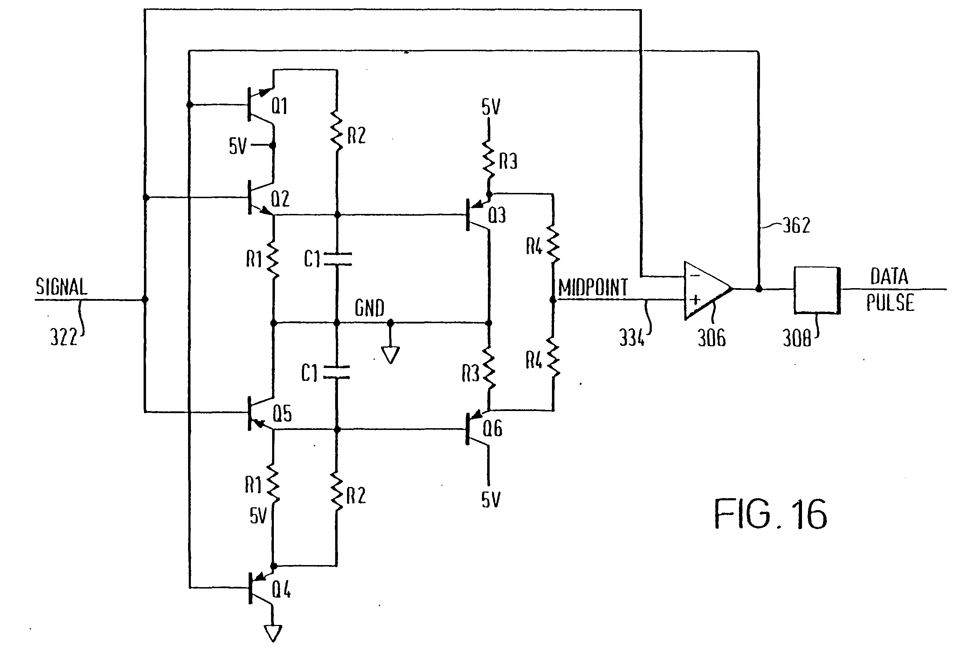

The output of the dual edge circuit 350 provides clocking and data information from which recovery of the recorded data may be had in a straightforward manner. For example, in a pulse-width modulation (〈〈PWM〉〉 technique such as the GCR 8/9 modulation code described previously, each data pulse output from the dual edge circuit 350 represents a transition in flux (i. e., a recorded 1-bit), while the lack of data pulse at clock intervals would represent the lack of transition in flux (i.e., a recorded 0-bit). The sequence of recorded bits can thereafter be decoded by decoder 24 (shown in Fig. 1) by methods well known in the art to determine the original data.
In order to properly track the envelope caused by the DC portion of the preprocessed signal 322, a preferred embodiment feeds back duty cycle information from the output signal 362 to the peak detectors. Thus, the output of the comparator 306 is fed back to the positive peak detector 300 and the negative peak detector 302. This process may be explained further by reference to Fig. 16 which depicts a more detailed circuit diagram of the data generator stage 210. As shown in Fig. 16, the preprocessed signal 322 is provided to the base of transistors Q2 and Q5. Transistor Q2 is associated with the positive peak detector 300, and transistor Q5 is associated with the negative peak detector 302. Because the positive peak detector 300 and negative peak detector 302 operate in an analogous fashion, the duty cycle feedback operation will be explained only with reference to the positive peak detector 300, while those skilled in the art will understand by perusal of Fig. 16 and the description below the analogous operation of negative peak detector 302.
Transistor Q2 charges a capacitor C1 when the amplitude of the preprocessed signal 322 exceeds the stored voltage of the capacitor C1 (plus the forward bias voltage of the transistor Q2). In Fig. 17, it can be seen that the positive peak output signal 330 charges rapidly to the peak of the signal 332. The output signal 362, through feedback, maintains the positive charge on the capacitor C1 when the output signal 362 is high and allows the capacitor C1 to discharge when the output signal 362 is low. Thus, if the output signal 362 is high, the positive charge on capacitor C1 is maintained by transistor Q1 through resistor R2. Preferably, resistors R1 and R2 are selected to be the same value so that charge is added to the capacitor through resistor R2 at the same rate that it is discharged through resistor R1, thus maintaining as constant the net charge on capacitor C1. If, on the other hand, the output signal 362 is low, then transistor Q1 is turned off and capacitor C1 is allowed to discharge though resistor R1. The values of capacitor C1 and resistor R1 are preferably selected such that the time constant is slightly faster than the speed of expected of DC buildup so that the capacitor C1 can track the change in DC level as it occurs.
The output of capacitor C1 is provided to the base of transistor Q3. The voltage level of the emitter of Q3 is a bias voltage level above the output of capacitor C1. Current is drawn through resistor R3 which allows the emitter of transistor Q3 to follow the voltage of the capacitor C1 (offset by the emitter-base bias voltage). Thus, the emitter of transistor Q3 yields positive peak output signal 330. It should be noted that transistors Q1 and Q2 are NPN type transistors while Q3 is a PNP type resistor. Thus, the NPN-PNP configuration largely cancels out adverse thermal effects that may be experienced with transistors Q1, Q2 and Q3 and also cancels out the bias voltages associated with their operation.
The negative peak detector 302 operates in an analogous fashion to the positive peak detector 300 and is therefore not explained in greater detail. The emitter of transistor Q6 yields negative peak output signal 332.
As described previously, positive peak output signal 330 and negative peak output signal 332 are averaged by a voltage divider 304 comprised of pair of resistors R4 as shown in Fig. 16 to form threshold signal 334. The threshold signal 334 therefore constitutes the approximate midpoint of the peak-to-peak value of the preprocessed signal 322 tracks the DC envelope of the preprocessed signal 322 through duty cycle feedback compensation. Although the duty cycle feedback has been shown in the preferred embodiment as originating from the output of the comparator 306, it may be observed that other feedback paths may also be utilized. For example, a similar feedback path may be taken from the output of dual edge circuit 308 if a flip flop or other memory element is placed at the output of the dual edge circuit 308. Also, other means for measuring duty cycle and adjusting the threshold signal to track the DC envelope may be utilized.
A preferred technique such as described generally in Figs. 12 and 13 includes the step of differentiation of the playback signal prior to partial integration, followed thereafter by the step of DC tracking. The preferred method is particularly suitable for systems having a playback signal with relatively poor resolution, and may be advantageously applied, for example, to reading information stored in a GCR format. In one aspect of the preferred method, the initial step of differentiation reduces the low frequency component from the incoming playback signal. In another aspect of the preferred method, the partial integration stage results in restoration or partial restoration of the playback signal while providing rapid response due to the high pass boost (e.g., from the bandpass filter stage). The preferred method may be contrasted with a method in which integration of the playback signal is carried out initially (i.e., prior to differentiation), which may lead to an increased size of DC component and a correspondingly more difficult-time in tracking the DC component.

### Alternate Embodiments

It will be appreciated that the various circuits and methods described herein are not limited to magneto-optical systems but may also be useful in systems for reading data on stored tapes and other types of disks as well and, in a more general sense, in any system (whether or not a data storage system) for processing electrical signals in which it is desired to mitigate the effects of DC buildup.
While the invention has been particularly shown and described with reference to certain embodiments, it will be understood by those skilled in the art that various changes in form and detail may be made without departing from the spirit and scope of the invention.

## Claims

**1.** An apparatus for retrieving stored data from an information storage medium, said apparatus comprising:
an input stage for generating a signal having a predetermined waveform including positive and negative peaks corresponding to said stored data;
an integrator stage for integrating at least a portion of said signal to output a preprocessed signal having a predetermined waveform including said positive peaks, negative peaks, and a DC component;
a data generator for generating a threshold signal which varies with said DC component of said preprocessed signal, and for generating an output data waveform signal indicative of said stored data by comparing said preprocessed signal and said threshold signal, said data generator including;
a positive peak detector for receiving said preprocessed signal to measure and track said positive peaks and to output a positive peak signal;
a negative peak detector for receiving said preprocessed signal to measure and track said negative peaks and to output a negative peak signal;
a voltage divider for averaging said negative peak signal and said positive peak signal to thereby generate a voltage divider output; and
a comparator for receiving said voltage divider output and comparing said preprocessed signal with a divided voltage corresponding to said threshold signal to thereby generate said output data waveform signal.

**2.** The apparatus according to claim 1 wherein said information storage medium includes a magneto-optical disk.

**3.** The apparatus according to claim 1 wherein said input stage includes a scanner for scanning said information storage medium to generate an input signal, and a differentiator for differentiating said input signal.

**4.** The apparatus according to claim 3 further including an amplifier for amplifying said input signal.

**5.** The apparatus according to claim 1 wherein said integrator stage includes an integrator for integrating said signal, a band-pass filter for filtering said signal, and a subtractor for generating said preprocessed signal representing the difference between said integrated signal and said band-pass filtered signal.

**6.** The apparatus according to claim 5 further including a low pass filter for filtering the integrated signal.

**8.** The apparatus according to claim 7 further comprising a feedback path from said output data waveform signal to the positive and negative peak detectors for adjusting said positive peak signal and said negative peak signal as a function of a predetermined state of said output data waveform signal.

**9.** The apparatus according to claim 8 wherein said positive peak signal is adjusted by decreasing its magnitude when said output data waveform signal is in alternatively one of a low state and a high state, and said negative peak signal is adjusted by decreasing its magnitude when said output data waveform signal is in the other of said low and high states.

**10.** The apparatus according to claim 1 wherein said comparator changes states when said preprocessed signal crosses said threshold signal thereby indicating a transition in read data between a 1 and a 0.

**11.** The apparatus according to claim 1 further including a dual edge circuit for receiving said output data waveform signal from said comparator to generate a unipolar pulse of fixed duration each time said comparator changes states.

**12.** The apparatus according to claim 11 wherein said dual edge circuit provides clocking and data information from which recovery of the stored data may be obtained.

**13.** A data generator assembly for use in retrieving stored data from an information storage medium, said data generator circuit comprising:
a positive peak detector for receiving a preprocessed signal having a predetermined waveform including positive peaks, negative peaks, and a DC component, said positive peak detector measuring and tracking said positive peaks to thereby output a positive peak signal;
a negative peak detector for receiving said preprocessed signal, said negative peak detector measuring and tracking said negative peaks to thereby output a negative peak signal;
a voltage divider for averaging said negative peak signal and said positive peak signal, said voltage divider generating a threshold signal representing the approximate peak-to-peak midpoint of the preprocessed signal thereby varying with said DC component;
a comparator for comparing said preprocessed signal with said threshold signal, said comparator generating an output data waveform signal indicative of the stored data on information storage medium; and
a feedback loop for appling to said positive peak detector and said negative peak detector a feedback signal representative of a duty cycle of said output data waveform signal thereby compensating for an expected value of said DC component

**14.** The data generator assembly according to claim 13 wherein said comparator changes states when said preprocessed signal crosses said threshold signal thereby indicating a transition in read data between a 1 and a 0.

**15.** The data generator assembly according to claim 13 further including a dual edge circuit for receiving said output data waveform signal from said comparator to generate a unipolar pulse of fixed duration each time said comparator changes states.

**16.** The data generator assembly according to claim 15 wherein said dual edge circuit provides clocking and data information from which recovery of the stored data may be obtained.

**17.** A method for retrieving data stored on a medium (1 8) comprising the steps of:
reading said stored data and generating a playback signal thereby,
partially integrating said playback signal,
generating a threshold signal (334) which varies with a DC component of said partially integrated signal (322), and
generating an output signal indicative of said stored data by comparing said partially integrated signal (322) with said threshold signal (334).

**18.** The method of claim 17 further comprising the step of differentiating said playback signal prior to the step of partially integrating.

**19.** The method of claims 17 to 18 wherein said step of partially integrating comprises:
integrating said playback signal,
simultaneously with but separately from said integrating, bandpass filtering said playback signal, and
taking a difference between said integrated signal and said bandpass filtered signal.

**20.** The method of claims 17 to 19 further comprising the step of low pass filtering said difference signal.

**21.** The method of claims 17 to 20 wherein said step of generating a threshold signal (334) comprises:
detecting a positive peak voltage of said partially integrated signal (322),
detecting a negative peak voltage of said partially integrated signal (322), and
averaging said positive peak voltage and said negative peak voltage.

**22.** The method of claims 17 to 21 further comprising the step of adjusting said threshold signal (334) in response to a state of said output signal.

**23.** An apparatus for retrieving data stored on a medium (18) comprising:
a reader (20) for said stored data, said reader (20) generating an input signal thereby,
a partial integrator (208) connected to said signal,
a threshold generator (236) connected to said partial integrator (208),
a data generator (210) connected to said partial integrator (208) and to said threshold generator (236), said data generator (210) comprising a comparator (306), and
a feedback path (362) from said comparator (306) to said threshold generator (236).

**24.** The apparatus of claim 23 wherein said reader (20) comprises a differentiator (204).

**25.** The apparatus of claims 23 to 24 wherein said threshold generator (236) generates a threshold signal (334) which varies with a DC component of said signal.

**26.** The apparatus of claims 23 to 25 wherein said comparator (306) is connected to an output from said threshold generator (236) and an output of said partial integrator (208).

**27.** The apparatus of claims 23 to 26 wherein said partial integrator (208) comprises:
an integrator (232) connected to said signal,
a bandpass filter (230) connected to said signal, and
a subtractor (234) connected to an output of said integrator (232) and output of said bandpass filter (230).

**28.** The apparatus of claim 27 further comprising a low pass filter connected to an output of said subtractor (232).

**29.** The apparatus of claims 23 to 28 wherein said threshold generator (236) comprises:
a positive peak voltage detector connected to said partial integrator (208),
a negative peak voltage detector (302) connected to said partial integrator (208), and
a voltage divider (304) connected to an output of said positive peak voltage detector (300) and an output of said negative peak voltage detector (302).

**30.** The apparatus of claims 23 to 29 wherein said feedback path (362) is connected to said positive peak voltage detector (300) and to said negative peak voltage detector (302), and causes an adjustment to a detected positive peak voltage or to a detected negative peak voltage in dependence on a state of said feedback path (362).

**31.** The apparatus of claim 30 wherein said detected positive peak voltage is adjusted by decreasing its magnitude when said feedback path (362) is in one of two states, and said-detected negative peak voltage is adjusted by decreasing its magnitude when said feedback path (362) is in another of said two states.

**32.** A method for storing digital data on an optical disk comprising the steps of:
generating a binary signal having first and second binary values at a given clock interval representative of the data;
generating energizing pulses having a duration less than the clock interval during each clock interval having one of the binary values;
directing a focused laser at the recording surface of a rotating optical disk such that the laser beam can selectively access one of a plurality of concentric tracks on the recording surface; and
applying the energizing pulses to the laser to turn the laser beam on and off depending upon the value of the binary signal.

**33.** Apparatus for recording data on an optical disk comprising:
a source of digital data occurring at a given clock interval;
means for converting the data to a binary signal having first and second binary values at a given clock interval representative of the data;
an optical. data storage disk having a recording surface;
means for rotatably driving the disk-,
a laser having a focused beam;
means for directing the laser at the recording surface such that the laser beam can access one of a plurality of concentric tracks on the recording surface;
means for generating energizing pulses having a duration less than a clock interval for converted data having the first binary value; and
means for applying the energizing pulses to the laser to turn the laser beam on and off responsive to the energizing pulses.

**34.** The apparatus of claim 33, wherein said converting means forms a binary signal that always changes value within a predetermined multiple of the clock interval.

**35.** The apparatus of claim 34, wherein said predetermined multiple is three.

**36.** The apparatus of claim 33, wherein said converting means forms a binary signal that follows eight to nine group code recording (GCR).

**37.** The apparatus of claim 33 wherein said applying means further comprises:
means for detecting predetermined sequences of converted data; and
means for adjustng the fine of applying the energizing pulses upon the occurrence of a predetermined data sequence.

**38.** The apparatus of claim 37, wherein said predetermined data patterns comprise the data sequences 1100, 10100, 00100, and 000111.

**39.** A method of retrieving digital data on an optical disk comprising the steps of:
directing a focused laser at the recorded surface of a rotating optical disk such that the laser beam can
selectively access one of a plurality of concerttric tracks on the recorded surface;
detecting the rotation of the laser beam reflected off of the recorded surface, a change in rotation to the first type representing the first binary value and a change in rotation to the second type representing the second binary value; and
generating a binary signal that represents the binary values that occur at a clock interval generated from the occurrences of the binary values and changes in reflectivity occurring at boundaries of the clock interval.

**40.** An apparatus for reading data on an optical disk comprising:
an optical data storage disk having a recorded surface;
means for rotatably driving the disk;
a laser having a focused beam;
means for directing the laser at the recorded surface such that the laser beam can selectively access one of a plurality at concentric tracks on the recorded surface;
means for detecting the rotation of the laser beam reflected off of the recorded surface;
means for converting changes in rotation to the first type into the first binary value and changes in rotation to the second type into the second, binary value; and
means for generating a binary signal that represents the binary values that occur at a clock interval generated from the occurrences of the binary values and changes in reflectvity occurring at boundaries of the clock interval.

**41.** The apparatus of claim 40, wherein said converting means forms a binary signal that follows eight to nine group code recording (GCR) decoding.

**42.** The apparatus of claim 40 wherein said detecting means further comprises means for altering the shape of the detected signal.

**43.** The apparatus of claim 42 wherein said altering means further comprises means for narrowing the width and increasing the amplitude of pulses of the detected signal.

**44.** The apparatus of claim 43 wherein detecting means further-comprises means for adjusting the threshold of sensitivity of the detecting means to overshoots in the detected rotation.

**45.** An optical data storage and retrieval system comprising:
a source of digital data;
first means for encoding digital data in a first format higher in density than ANSI;
second means for encoding digital data in a second ANSI format;
means for utilizing digital data;
first means for decoding digital data from the first format;
second means for decoding digital data from the second format;
a disk drive for receiving a replaceable 90 millimeter optical disk ;
means for reading encoded data from and writing encoded data on a 90 millimeter optical disk received by the drive;
means in a first mode for connecting the first encoding means between the source and the reading and writing means and the first decoding means between the reading and writing means and the utilizing means;
means in a second mode for connecting the second encoding means between the source and the reading and writing means and the second decoding means between the reading and writing means and the utilizing means; and
means for switching between the first and second modes.
